# EUROPEAN PATENT APPLICATION

(11) **EP 4 401 310 A1**
(43) Date of publication of application: **17.07.2024**
(21) Application number: 22866493.4
(22) Date of filing: 31.08.2022
(51) Int. Cl.: H03H 9/02, H03H 9/17, H03H 9/54, H04B 1/40

(54) **BULK ACOUSTIC WAVE RESONANCE DEVICE, FILTER DEVICE, AND RADIO FREQUENCY FRONT-END DEVICE**

(30) Priority: 08.09.2021 CN 202111054656
(71) Applicant: Changzhou Chemsemi Co., Ltd., Changzhou, Jiangsu 213166 (CN)
(72) Inventor: ZOU, Yali, Changzhou, Jiangsu 213166 (CN)
(74) Representative: Piticco, Lorena
(86) International application number: PCT/CN2022/116066
(87) International publication number: WO 2023/036028

(57) **Abstract**

Provided in the embodiments of the present invention are a bulk acoustic wave resonance device, a filter device, and a radio frequency front-end device. The bulk acoustic wave resonance device comprises: a first layer comprising a cavity; a first electrode layer having at least one end located in the cavity; a piezoelectric layer, which is located on the first electrode layer to cover the cavity and comprises a first side and a second side that is opposite the first side in a vertical direction, the first electrode layer being located on the first side; a second electrode layer located on the second side and on the piezoelectric layer; and at least one edge structure, which is located at an edge of an overlapping portion of the first electrode layer and the second electrode layer in a horizontal direction and is of an asymmetric structure in the vertical direction with respect to the piezoelectric layer. The acoustic impedance of an edge portion where the at least one edge structure is located does not match the acoustic impedance of a middle portion between the at least one edge structure, that is, the acoustic impedances are different, such that leaky waves can be blocked in a transverse mode and a Q value can be increased.

## Description

### CROSS-REFERENCE TO RELATED APPLICATIONS

This application claims the benefit of priority to Chinese Patent Application No. 202111054656.8, filed on September 8, 2021, and entitled "**BULK ACOUSTIC WAVE RESONANCE DEVICE, FILTER DEVICE, AND RADIO FREQUENCY FRONT-END DEVICE**", the contents of which are incorporated herein by reference in their entireties.

### TECHNICAL FIELD

The present disclosure relates to the field of semiconductor technology, and specifically to a bulk acoustic wave resonance device, a filter device, and a radio frequency front-end device.

### BACKGROUND

A Radio Frequency (RF) front-end chip of a wireless communication device includes a power amplifier, an antenna switch, a radio frequency filter, a multiplexer, and a low noise amplifier, etc. The radio frequency filter includes a Surface Acoustic Wave (SAW) filter, a Bulk Acoustic Wave (BAW) filter, a Micro-Electro-Mechanical System (MEMS) filter, and an Integrated Passive Device (IPD) filter, etc.

As both a SAW resonator and a BAW resonator have a high quality value (Q value), a radio frequency filter including either a SAW resonator, namely a SAW filter, or a BAW resonator, namely a BAW filter, has low insertion loss and high out-band rejection, and thus become a mainstream radio frequency filter applied to wireless communication devices such as mobile phones and base stations. The Q value is a quality factor value of a resonator, and is defined by a center frequency divided by 3 dB bandwidth of the resonator. An effective frequency of a SAW filter typically ranges from 0.4 GHz to 2.7 GHz and an effective frequency of a BAW filter typically ranges from 0.7 GHz to 7 GHz.

BAW resonators have a good performance over SAW resonators, however, BAW resonators have a higher cost comparing with SAW resonators due to more complicated manufacturing process. As wireless communication technology gradually evolves, more and more frequency bands are developed. Moreover, due to implementation of frequency band superposition technology such as carrier aggregation, mutual interference between wireless frequency bands becomes increasingly serious. High performance BAW technology can solve the problem of mutual interference between frequency bands. With the advent of the 5G era, wireless mobile networks have adopted higher communication frequency bands, and BAW technology can provide solutions to the filtering problem in the high-frequency band so far.

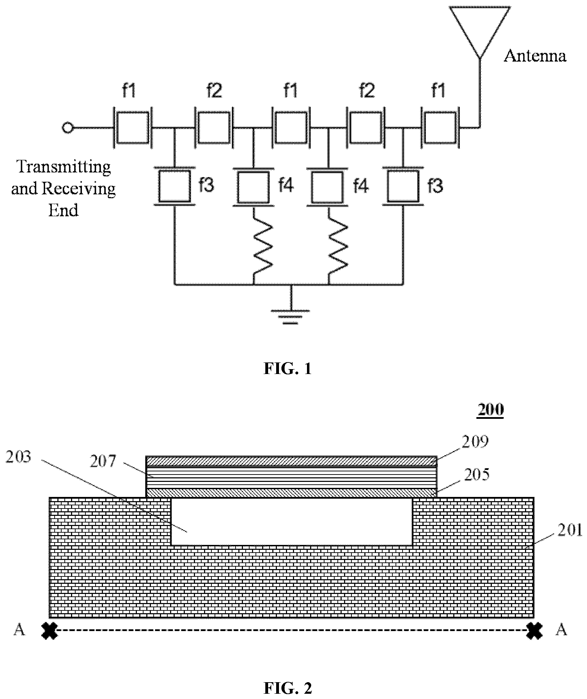

FIG. 1 illustrates a circuit of a BAW filter including a ladder circuit consisting of a plurality of BAW resonators, wherein fl, f2, f3 and f4 represent four different frequencies, respectively. Within each BAW resonator, alternating voltages with different polarities are supplied to metal electrodes at both sides of a piezoelectric layer of the resonator, acoustic waves is generated by the piezoelectric layer under the alternating voltages with different polarities, and the acoustic waves within the resonator propagates in a direction perpendicular to the piezoelectric layer. In order to form resonance, the acoustic waves require total reflection on an upper surface of an upper metal electrode and on a lower surface of a lower metal electrode to form a standing acoustic wave. A condition for an acoustic wave reflection is that acoustic impedance of medium in contact with the upper surface of the upper metal electrode and the lower surface of the lower metal electrode differs greatly from that of the metal electrodes.

A Film Bulk Acoustic wave Resonator (FBAR) is a kind of BAW resonator which can restrain acoustic wave energy inside the resonator. Air or vacuum is configured above a resonance region of the BAW resonator, and a cavity is configured below the resonance region of the BAW resonator. Because acoustic impedance of air and vacuum differs greatly from that of metal electrodes, acoustic waves can be totally reflected on an upper surface of an upper metal electrode and a lower surface of a lower metal electrode to form standing waves.

FIG. 2 schematically illustrates a structural diagram of a cross-section A of a FBAR 200. The FBAR 200 includes: a substrate 201, a cavity 203 disposed in the substrate 201, an electrode layer 205 (i.e., a lower electrode layer) disposed on the substrate 201 and covering the cavity 203, a piezoelectric layer 207 disposed on the electrode layer 205 and an electrode layer 209 (i.e., an upper electrode layer) disposed on the piezoelectric layer 207. The electrode layer 205, the piezoelectric layer 207 and the electrode layer 209 form a resonance region of the FBAR 200. It should be noted that, there are two propagation modes of acoustic waves in the resonance region: longitudinal mode and transverse mode. In the longitudinal mode, acoustic waves propagate along a direction of a thickness of the piezoelectric layer. In the transverse mode, acoustic waves propagate along a direction perpendicular to the propagation direction in longitudinal mode. At lateral edges of the resonance region, leakage of acoustic waves may occur in the transverse mode, which results in acoustic energy loss so as to lower the Q value.

### SUMMARY

A bulk acoustic wave resonance device is provided by the present disclosure, which can cut down leakage waves at lateral edges of the resonance region in the transverse mode so as to raise the Q value.

Some embodiments of the present disclosure provide a bulk acoustic wave resonance device. The bulk acoustic wave resonance device includes: a first layer including a cavity, a first electrode layer, a piezoelectric layer disposed on the first electrode layer and covering the cavity, a second electrode layer, and at least one edge structure. At least one end of the first electrode layer is disposed in the cavity. The piezoelectric layer includes a first side and a second side opposite to the first side along a vertical direction. The first electrode layer is disposed at the first side, and the second electrode layer is disposed at the second side and on the piezoelectric layer. The at least one edge structure is disposed at an edge of an overlap part of the first electrode layer and the second electrode layer along a horizontal direction, and the at least one edge structure is asymmetrical with respect to the piezoelectric layer along the vertical direction.

It should be noted that, the edge part of the resonance region, where the edge structure is disposed, does not match a middle part of the resonance region inside the edge structure in acoustic impedance (that is, the acoustic impedances are different), which can cut down leakage waves at lateral edges of the resonance region in the transverse mode so as to raise the Q value.

According to some embodiments, the at least one edge structure includes a first edge structure disposed at the second side and on the second electrode layer, and the first edge structure includes a first edge surrounding part and a first extension part. The first edge surrounding part is disposed at the edge of the overlap part of the first electrode layer and the second electrode layer. The first extension part is connected to the first edge surrounding part and is disposed at an outer side of the overlap part of the first electrode layer and the second electrode layer. The first extension part does not overlap with the first electrode layer, resulting in a reduction to the resistance in electrical transmission. According to some embodiments, the first edge surrounding part is in an annular shape. According to some embodiments, the first edge structure is made of a material including metal.

According to some embodiments, the at least one edge structure includes a second edge structure, and the first electrode layer is disposed on the second edge structure. The second edge structure includes a second edge surrounding part and a second extension part. The second edge surrounding part is disposed in the cavity and disposed at the edge of the overlap part of the first electrode layer and the second electrode layer. The second extension part is connected to the second edge surrounding part and is disposed at an outer side of the overlap part of the first electrode layer and the second electrode layer. The second extension part does not overlap with the second electrode layer, resulting in a reduction to the resistance in electrical transmission. According to some embodiments, the second edge surrounding part is in an annular shape. According to some embodiments, the second edge structure is made of a material including metal.

According to some embodiments, the at least one edge structure includes a third edge structure disposed at the second side and on the second electrode layer. The third edge structure includes a third edge surrounding part, and the third edge surrounding part is disposed at a part of the edge of the overlap part of the first electrode layer and the second electrode layer. According to some embodiments, the at least one edge structure further includes a fourth edge structure, and the first electrode layer is disposed on the fourth edge structure. The fourth edge structure includes a fourth edge surrounding part, and the fourth edge surrounding part is disposed in the cavity and disposed at a part of the edge of the overlap part of the first electrode layer and the second electrode layer. According to some embodiments, the third edge surrounding part and the fourth edge surrounding part are disposed at both sides of the piezoelectric layer and form an asymmetrical structure along the vertical direction, and the third edge surrounding part and the fourth edge surrounding part partially overlap to form an annular surrounding edge. According to some embodiments, the third edge structure is made of a material including metal, and the fourth edge structure is made of a material including metal.

According to some embodiments, the at least one edge structure includes a fifth edge structure disposed at the second side and on the piezoelectric layer, and the fifth edge structure includes a fifth edge surrounding part and a fifth extension part. An overlap part of the fifth edge surrounding part and the first electrode layer is formed along the vertical direction, and the second electrode layer is disposed at an inner side of the overlap part of the fifth edge surrounding part and the first electrode layer. An overlap part of the second electrode layer overlapping with the first electrode layer is equivalent to the second electrode layer. The fifth extension part is connected to the fifth edge surrounding part and is disposed at an outer side of the overlap part of the fifth edge surrounding part and the first electrode layer, and the fifth extension part does not overlap with the first electrode layer, resulting in a reduction to the resistance in electrical transmission. According to some embodiments, the fifth edge surrounding part is in an annular shape. According to some embodiments, the fifth edge structure is made of a material including metal.

According to some embodiments, the at least one edge structure includes a sixth edge structure disposed at the first side, and the piezoelectric layer is disposed on the sixth edge structure. The sixth edge structure includes a sixth edge surrounding part and a sixth extension part. The sixth edge surrounding part is disposed in the cavity. An overlap part of the sixth edge surrounding part and the second electrode layer is formed along the vertical direction. The first electrode layer is disposed at an inner side of the overlap part of the sixth edge surrounding part and the second electrode layer. An overlap part of the first electrode layer overlapping with the second electrode layer is equivalent to the first electrode layer. The sixth extension part is connected to the sixth edge surrounding part and is disposed at an outer side of the overlap part of the sixth edge surrounding part and the second electrode layer. The sixth extension part does not overlap with the second electrode layer, resulting in a reduction to the resistance in electrical transmission. According to some embodiments, the sixth edge surrounding part is in an annular shape. According to some embodiments, the sixth edge structure is made of a material including metal.

According to some embodiments, the at least one edge structure includes a seventh edge structure disposed at the second side and on the piezoelectric layer. The seventh edge structure includes a seventh edge surrounding part, and the seventh edge surrounding part is disposed at a part of the edge of the overlap part of the first electrode layer and the second electrode layer. According to some embodiments, the at least one edge structure further includes an eighth edge structure disposed at the first side, and the piezoelectric layer is disposed on the eighth edge structure. The eighth edge structure includes an eighth edge surrounding part, and the eighth edge surrounding part is disposed in the cavity and disposed at a part of the edge of the overlap part of the first electrode layer and the second electrode layer. According to some embodiments, the seventh edge surrounding part and the eighth edge surrounding part are disposed at both sides of the piezoelectric layer and form an asymmetrical structure along the vertical direction, and the eighth edge surrounding part and the seventh edge surrounding part partially overlap to form an annular surrounding edge. According to some embodiments, the seventh edge structure is made of a material including metal, and the eighth edge structure is made of a material including metal.

According to some embodiments, the first layer includes an intermediate layer, the intermediate layer includes the cavity, and the intermediate layer is made of a material including at least one selected from but not limited to a group consisting of polymer, insulating dielectric, and polysilicon.

According to some embodiments, the piezoelectric layer includes crystal grains, the crystal grains include but not limited to a first crystal grain and a second crystal grain, and the first crystal grain and the second crystal grain are any two crystal grains of the crystal grains. A first coordinate axis along a first direction corresponds to a height of the first crystal grain, a second coordinate axis along a second direction corresponds to a height of the second crystal grain, and the first direction is the same as or opposite to the second direction. According to some embodiments, the first crystal grain corresponds to a first coordinate system, and the first coordinate system includes the first coordinate axis and a third coordinate axis along a third direction. The second crystal grain corresponds to a second coordinate system, and the second coordinate system includes the second coordinate axis and a fourth coordinate axis along a fourth direction. According to some embodiments, the first coordinate system further includes a fifth coordinate axis along a fifth direction, and the second coordinate system further includes a sixth coordinate axis along a sixth direction. According to some embodiments, the third direction is the same as or opposite to the fourth direction.

According to some embodiments, the piezoelectric layer includes crystal grains, and a crystal composed of crystal grains has a full width at half maximum of a rocking curve less than 2.5 degrees.

Some embodiments of the present disclosure also provide a filter device which includes but not limited to: at least one bulk acoustic wave resonance device according to any one of preceding embodiments.

Some embodiments of the present disclosure also provide a radio frequency front-end device which includes but not limited to: a power amplification device and at least one filter device according to any one of preceding embodiments. The power amplification device is coupled with the at least one filter device.

Some embodiments of the present disclosure also provide a radio frequency front-end device which includes but not limited to: a low noise amplification device and at least one filter device according to any one of preceding embodiments. The low noise amplification device is coupled with the at least one filter device.

Some embodiments of the present disclosure also provide a radio frequency front-end device which includes but not limited to a multiplexing device, and the multiplexing device includes at least one filter device according to any one of preceding embodiments.

### BRIEF DESCRIPTION OF THE DRAWINGS

FIG. 1 schematically illustrates a structural diagram of a circuit 100 of a BAW filter device;
FIG. 2 schematically illustrates a structural diagram of a cross-section A of a FBAR 200;
FIG. 3a schematically illustrates a structural diagram of a cross-section A of a bulk acoustic wave resonance device 300 according to some embodiments of the present disclosure;
FIG. 3b schematically illustrates a structural diagram of crystal grains of a hexagonal system;
FIG. 3c (i) schematically illustrates a structural diagram of crystal grains of an orthorhombic system;

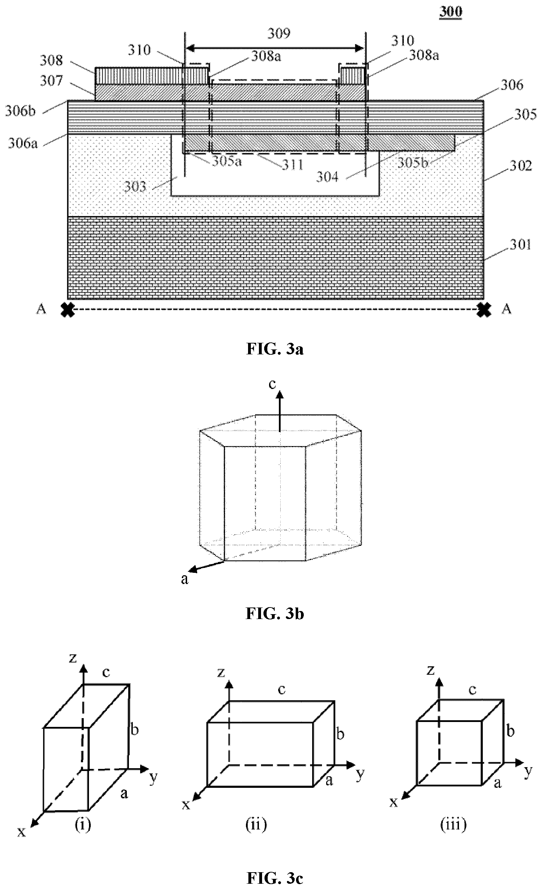

FIG. 3c (ii) schematically illustrates a structural diagram of crystal grains of a tetragonal system;
FIG. 3c (iii) schematically illustrates a structural diagram of crystal grains of a cubic system;

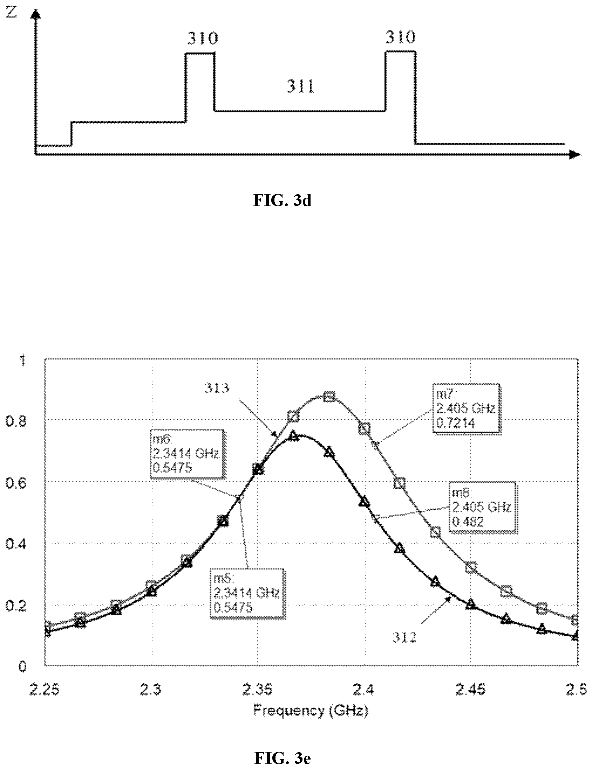

FIG. 3d schematically illustrates a diagram of an acoustic impedance of the bulk acoustic wave resonance device 300 according to some embodiments of the present disclosure;
FIG. 3e schematically illustrates a diagram of performance of the bulk acoustic wave resonance device 300 according to some embodiments of the present disclosure;

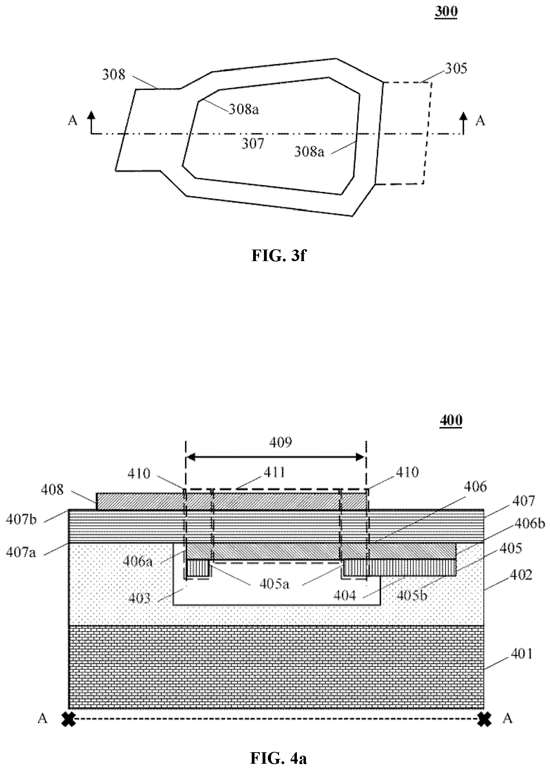

FIG. 3f schematically illustrates a top-view structural diagram of the bulk acoustic wave resonance device 300 according to some embodiments of the present disclosure;
FIG. 4a schematically illustrates a structural diagram of a cross-section A of a bulk acoustic wave resonance device 400 according to some embodiments of the present disclosure;

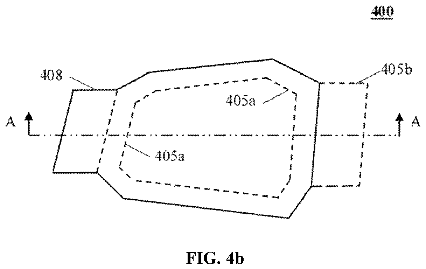

FIG. 4b schematically illustrates a top-view structural diagram of the bulk acoustic wave resonance device 400 according to some embodiments of the present disclosure;

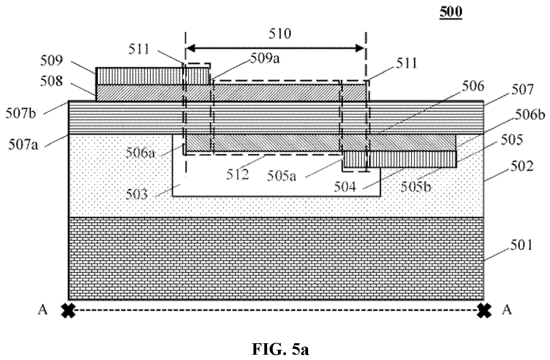

FIG. 5a schematically illustrates a structural diagram of a cross-section A of a bulk acoustic wave resonance device 500 according to some embodiments of the present disclosure;

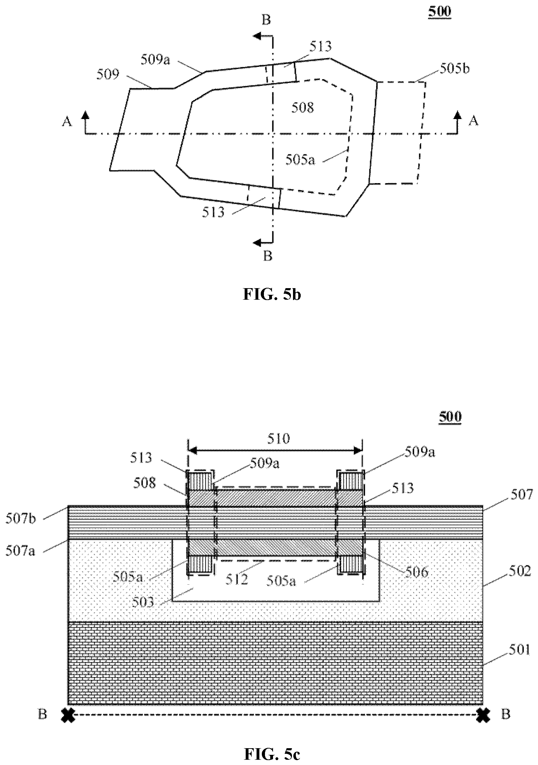

FIG. 5b schematically illustrates a top-view structural diagram of the bulk acoustic wave resonance device 500 according to some embodiments of the present disclosure;
FIG. 5c schematically illustrates a structural diagram of a cross-section B of the bulk acoustic wave resonance device 500 according to some embodiments of the present disclosure;

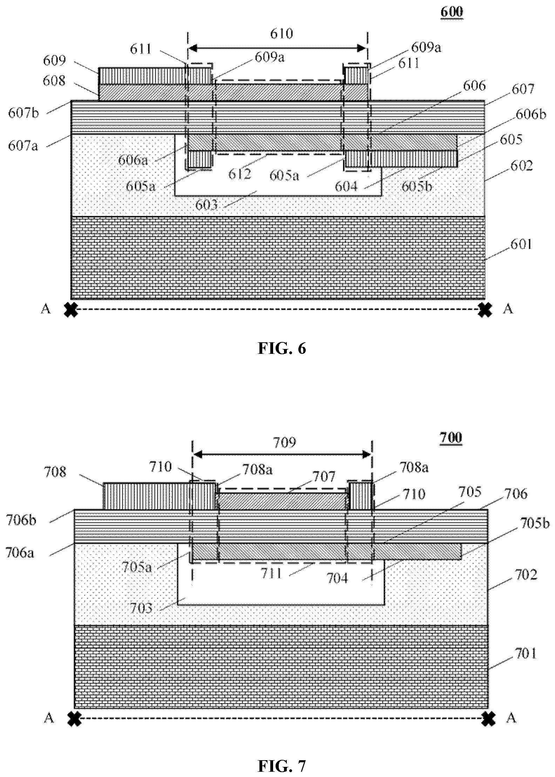

FIG. 6 schematically illustrates a structural diagram of a cross-section A of a bulk acoustic wave resonance device 600 according to some embodiments of the present disclosure;
FIG. 7 schematically illustrates a structural diagram of a cross-section A of a bulk acoustic wave resonance device 700 according to some embodiments of the present disclosure;

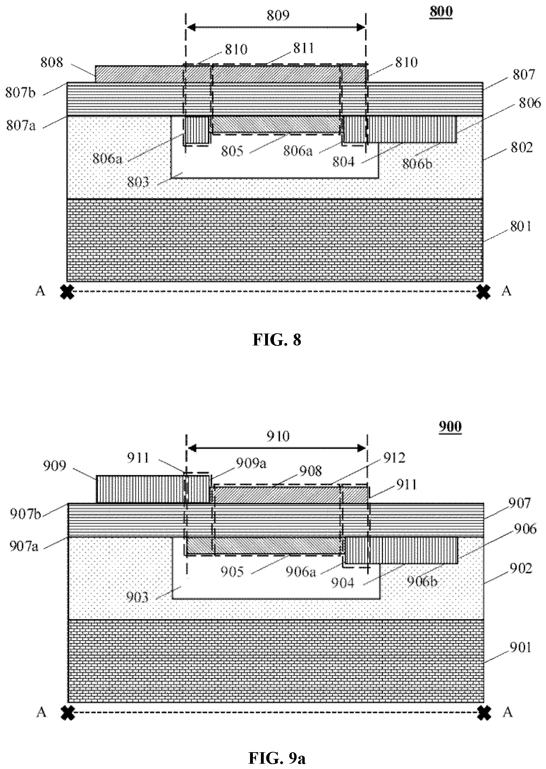

FIG. 8 schematically illustrates a structural diagram of a cross-section A of a bulk acoustic wave resonance device 800 according to some embodiments of the present disclosure;
FIG. 9a schematically illustrates a structural diagram of a cross-section A of a bulk acoustic wave resonance device 900 according to some embodiments of the present disclosure;

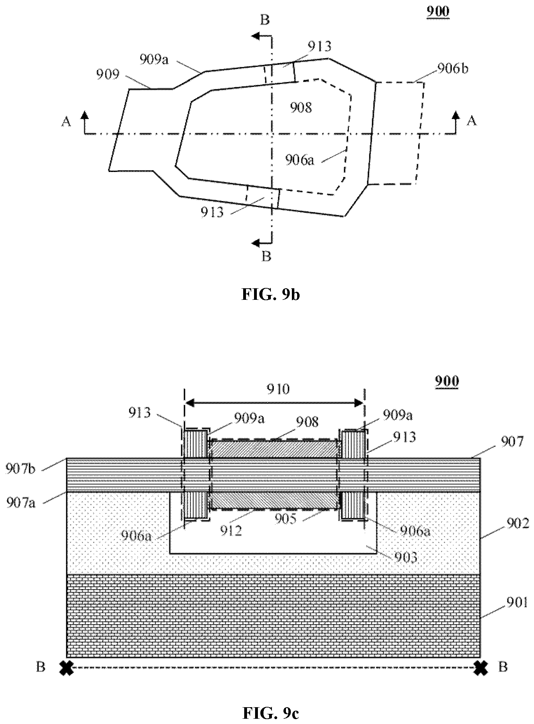

FIG. 9b schematically illustrates a top-view structural diagram of the bulk acoustic wave resonance device 900 according to some embodiments of the present disclosure;
FIG. 9c schematically illustrates a structural diagram of a cross-section B of the bulk acoustic wave resonance device 900 according to some embodiments of the present disclosure;

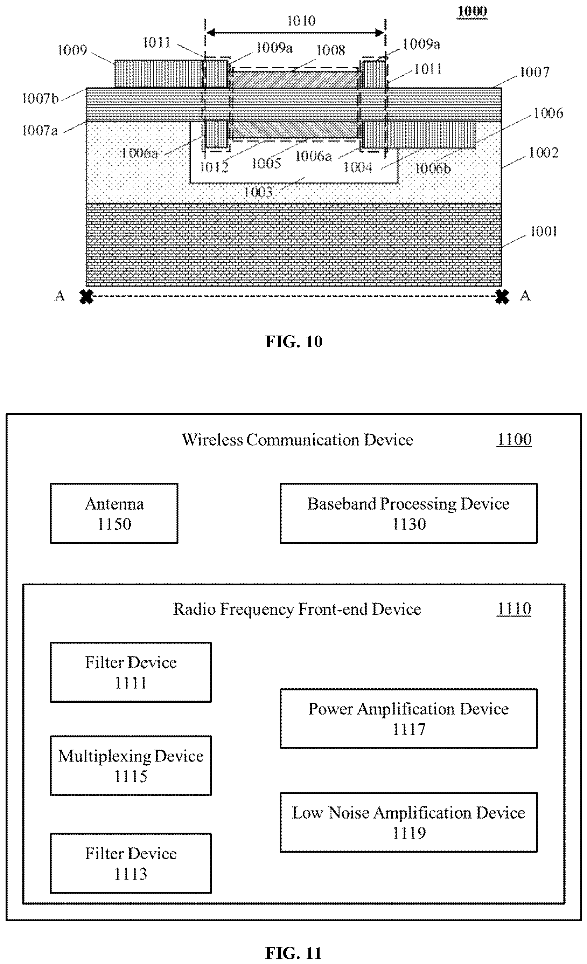

FIG. 10 schematically illustrates a structural diagram of a cross-section A of a bulk acoustic wave resonance device 1000 according to some embodiments of the present disclosure; and
FIG. 11 schematically illustrates a structural diagram of a wireless communication device 1100.

### DETAILED DESCRIPTION

In order to make above-mentioned purposes, features and advantages of the present disclosure more clear and understandable, specific embodiments of the present disclosure will be described in detail below in conjunction with the accompanying drawings.

In following description, specific details are set forth in order to provide a thorough understanding of the present disclosure, but the present disclosure may be practiced otherwise than as described herein, and therefore the present disclosure is not limited by the specific embodiments disclosed below.

As described in the background, there are two propagation modes of acoustic waves in the resonance region: the longitudinal mode and the transverse mode. In the longitudinal mode, acoustic waves propagate along a direction of a thickness of the piezoelectric layer. In the transverse mode, acoustic waves propagate along a direction perpendicular to the propagation direction in the longitudinal mode. At lateral edges of the resonance region, leakage of acoustic waves may occur in the transverse mode, which results in acoustic energy loss and thus lowers the Q value.

Inventors of the present disclosure have found that, the resonance region of the bulk acoustic wave resonance device is suspended relative to the cavity and has no overlap part with an intermediate layer of the bulk acoustic wave resonance device, the resonance region includes an edge structure, and an edge part, at where the edge structure is disposed, is different from a middle part disposed inside the edge structure in acoustic impedance, thus leakage waves in the transverse mode can be cut down so as to raise the Q value.

Some embodiments of the present disclosure provide a bulk acoustic wave resonance device. The bulk acoustic wave resonance device includes: a first layer including a cavity, a first electrode layer, a piezoelectric layer disposed on the first electrode layer and covering the cavity, a second electrode layer, and at least one edge structure disposed at an edge of an overlap part of the first electrode layer and the second electrode layer along a horizontal direction. At least one end of the first electrode layer is disposed in the cavity. The piezoelectric layer includes a first side and a second side opposite to the first side along a vertical direction. The first electrode layer is disposed at the first side, and the second electrode layer is disposed at the second side and on the piezoelectric layer. The at least one edge structure is disposed at an edge of an overlap part of the first electrode layer and the second electrode layer along a horizontal direction, and the at least one edge structure is asymmetrical with respect to the piezoelectric layer along the vertical direction.

According to some embodiments, the at least one edge structure includes a first edge structure disposed at the second side and on the second electrode layer, and the first edge structure includes a first edge surrounding part and a first extension part. The first edge surrounding part is disposed at the edge of the overlap part of the first electrode layer and the second electrode layer. The first extension part is connected to the first edge surrounding part and is disposed at an outer side of the overlap part of the first electrode layer and the second electrode layer. The first extension part does not overlap with the first electrode layer. It should be noted that the first extension part will reduce the resistance in electrical transmission by forming a thicker metal layer. Furthermore, the first extension part does not overlap with the first electrode layer, which may avoid generation of additional parasitic capacitance. According to some embodiments, the first edge surrounding part is in an annular shape. According to some embodiments, the first edge structure is made of a material including metal.

According to some embodiments, the at least one edge structure includes a second edge structure, and the first electrode layer is disposed on the second edge structure. The second edge structure includes a second edge surrounding part and a second extension part. The second edge surrounding part is disposed in the cavity and disposed at the edge of the overlap part of the first electrode layer and the second electrode layer. The second extension part is connected to the second edge surrounding part and is disposed at an outer side of the overlap part of the first electrode layer and the second electrode layer. The second extension part does not overlap with the second electrode layer. It should be noted that the second extension part will reduce the resistance in electrical transmission by forming a thicker metal layer. Furthermore, the second extension part does not overlap with the second electrode layer, which may avoid generation of additional parasitic capacitance. According to some embodiments, the second edge surrounding part is in an annular shape. According to some embodiments, the second edge structure is made of a material including metal.

According to some embodiments, the at least one edge structure includes a third edge structure disposed at the second side and on the second electrode layer. The third edge structure includes a third edge surrounding part, and the third edge surrounding part is disposed at a part of the edge of the overlap part of the first electrode layer and the second electrode layer. According to some embodiments, the at least one edge structure further includes a fourth edge structure, and the first electrode layer is disposed on the fourth edge structure. The fourth edge structure includes a fourth edge surrounding part, and the fourth edge surrounding part is disposed in the cavity and disposed at a part of the edge of the overlap part of the first electrode layer and the second electrode layer. According to some embodiments, the third edge surrounding part and the fourth edge surrounding part are disposed at both sides of the piezoelectric layer and form an asymmetrical structure along the vertical direction, and the third edge surrounding part and the fourth edge surrounding part partially overlap to form an annular surrounding edge. According to some embodiments, the third edge structure is made of a material including metal, and the fourth edge structure is made of a material including metal.

According to some embodiments, the at least one edge structure includes a fifth edge structure disposed at the second side and on the piezoelectric layer, and the fifth edge structure includes a fifth edge surrounding part and a fifth extension part. An overlap part of the fifth edge surrounding part and the first electrode layer is formed along the vertical direction, and the second electrode layer is disposed at an inner side (i.e., a side directing to a central axis of the resonance device) of the overlap part of the fifth edge surrounding part and the first electrode layer. An overlap part of the second electrode layer overlapping with the first electrode layer is equivalent to the second electrode layer. The fifth extension part is connected to the fifth edge surrounding part and is disposed at an outer side of the overlap part of the fifth edge surrounding part and the first electrode layer, and the fifth extension part does not overlap with the first electrode layer. It should be noted that the fifth extension part will reduce the resistance in electrical transmission by forming a thicker metal layer. Furthermore, the fifth extension part does not overlap with the first electrode layer, which may avoid generation of additional parasitic capacitance. According to some embodiments, the fifth edge surrounding part is in an annular shape. According to some embodiments, the fifth edge structure is made of a material including metal.

According to some embodiments, the at least one edge structure includes a sixth edge structure disposed at the first side, and the piezoelectric layer is disposed on the sixth edge structure. The sixth edge structure includes a sixth edge surrounding part and a sixth extension part. The sixth edge surrounding part is disposed in the cavity. An overlap part of the sixth edge surrounding part and the second electrode layer is formed along the vertical direction. The first electrode layer is disposed at an inner side of the overlap part of the sixth edge surrounding part and the second electrode layer. An overlap part of the first electrode layer overlapping with the second electrode layer is equivalent to the first electrode layer. The sixth extension part is connected to the sixth edge surrounding part and is disposed at an outer side of the overlap part of the sixth edge surrounding part and the second electrode layer, and the sixth extension part does not overlap with the second electrode layer. It should be noted that the sixth extension part will reduce the resistance in electrical transmission by forming a thicker metal layer. Furthermore, the sixth extension part does not overlap with the second electrode layer, which may avoid generation of additional parasitic capacitance. According to some embodiments, the sixth edge surrounding part is in an annular shape. According to some embodiments, the sixth edge structure is made of a material including metal.

According to some embodiments, the at least one edge structure includes a seventh edge structure disposed at the second side and on the piezoelectric layer. The seventh edge structure includes a seventh edge surrounding part, and the seventh edge surrounding part is disposed at a part of the edge of the overlap part of the first electrode layer and the second electrode layer. According to some embodiments, the at least one edge structure further includes an eighth edge structure disposed at the first side, and the piezoelectric layer is disposed on the eighth edge structure. The eighth edge structure includes an eighth edge surrounding part, and the eighth edge surrounding part is disposed in the cavity and disposed at a part of the edge of the overlap part of the first electrode layer and the second electrode layer. According to some embodiments, the seventh edge surrounding part and the eighth edge surrounding part are disposed at both sides of the piezoelectric layer and form an asymmetrical structure along the vertical direction, and the eighth edge surrounding part and the seventh edge surrounding part partially overlap to form an annular surrounding edge. According to some embodiments, the seventh edge structure is made of a material including metal, and the eighth edge structure is made of a material including metal.

According to some embodiments, the first layer includes an intermediate layer, the intermediate layer includes the cavity and the intermediate layer is made of a material including at least one selected from but not limited to a group consisting of polymer, insulating dielectric, and polysilicon.

According to some embodiments, the piezoelectric layer includes crystal grains, the crystal grains include but not limited to a first crystal grain and a second crystal grain, and the first crystal grain and the second crystal grain are any two crystal grains of the crystal grains. A first coordinate axis along a first direction corresponds to a height of the first crystal grain, a second coordinate axis along a second direction corresponds to a height of the second crystal grain, and the first direction is the same as or opposite to the second direction. According to some embodiments, the first crystal grain corresponds to a first coordinate system, and the first coordinate system includes the first coordinate axis and a third coordinate axis along a third direction. The second crystal grain corresponds to a second coordinate system, and the second coordinate system includes the second coordinate axis and a fourth coordinate axis along a fourth direction. According to some embodiments, the first coordinate system further includes a fifth coordinate axis along a fifth direction, and the second coordinate system further includes a sixth coordinate axis along a sixth direction. According to some embodiments, the third direction is the same as or opposite to the fourth direction.

According to some embodiments, the piezoelectric layer includes crystal grains, and a crystal composed of crystal grains has a full width at half maximum of a rocking curve less than 2.5 degrees.

Some embodiments of the present disclosure also provide a filter device which includes but not limited to: at least one bulk acoustic wave resonance device according to any one of preceding embodiments.

Some embodiments of the present disclosure also provide a radio frequency front-end device which includes but not limited to: a power amplification device and at least one filter device according to any one of preceding embodiments. The power amplification device is coupled with the at least one filter device.

Some embodiments of the present disclosure also provide a radio frequency front-end device which includes but not limited to: a low noise amplification device and at least one filter device according to any one of preceding embodiments. The low noise amplification device is coupled with the at least one filter device.

Some embodiments of the present disclosure also provide a radio frequency front-end device which includes but not limited to a multiplexing device, and the multiplexing device includes at least one filter device according to any one of preceding embodiments.

FIG. 3 to FIG. 10 illustrate specific embodiments of the present disclosure, and resonance devices in the specific embodiments have different structures. The present disclosure may also be implemented in other ways different from the specific embodiments described herein, and thus the present disclosure is not limited by the specific embodiments disclosed below.

FIG. 3a schematically illustrates a structural diagram of a cross-section A of a bulk acoustic wave resonance device 300 according to some embodiments of the present disclosure.

As shown in FIG. 3a, some embodiments of the present disclosure provide a bulk acoustic wave resonance device 300. The bulk acoustic wave resonance device 300 includes: a substrate 301; an intermediate layer 302 disposed on the substrate 301 and including a cavity 303 and a groove 304 disposed at an upper surface side of the intermediate layer 302; an electrode layer 305; a piezoelectric layer 306 disposed on the electrode layer 305 and on the intermediate layer 302; an electrode layer 307; and an edge structure 308. The groove 304 is disposed at one side of the cavity 303 and communicates with the cavity 303, and a depth of the groove 304 is less than a depth of the cavity 303. The electrode layer 305 includes a first end 305a disposed in the cavity 303 and a second end 305b disposed in the groove 304, and a depth of the groove 304 equals to a thickness of the electrode layer 305. The piezoelectric layer 306 covers the cavity 303 and includes a first side 306a and a second side 306b opposite to the first side 306a. The electrode layer 305 and the intermediate layer 302 are disposed at the first side 306a. The electrode layer 307 is disposed at the second side 306b and on the piezoelectric layer 306. The edge structure 308 is disposed at the second side 306b and on the electrode layer 307, the piezoelectric layer 306 and the edge structure 308 are respectively disposed at two sides of the electrode layer 307, and the edge structure 308 includes an edge surrounding part 308a disposed at an edge of an overlap part of the electrode layer 307 and the electrode layer 305.

As shown in FIG. 3a, a resonance region 309 (i.e., the overlap region of the electrode layer 305 and the electrode layer 307) is suspended relative to the cavity 303 and does not overlap with the intermediate layer 302. Therefore, acoustic waves in the transverse mode can be prevented from leaking into the intermediate layer 302 via lateral edges of the resonance region 309, so as to raise the Q value.

In some embodiments, the substrate 301 is made of one or more materials selected from but not limited to a group consisting of silicon, silicon carbide, glass, gallium arsenide, gallium nitride, and ceramic.

In some embodiments, the intermediate layer 302 is made of one or more materials selected from but not limited to a group consisting of polymer, insulating dielectric, and polysilicon. In some embodiments, the polymer includes, but is not limited to, at least one selected from a group consisting of benzocyclobutene (i.e., BCB), photosensitive epoxy resin photoresist (e.g., SU-8), and polyimide. In some embodiments, the insulating dielectric includes, but is not limited to, at least one selected from a group consisting of aluminum nitride, silicon dioxide, silicon nitride, and titanium oxide.

In some embodiments, the electrode layer 305 is made of one or more materials selected from but not limited to a group consisting of molybdenum, ruthenium, tungsten, platinum, iridium, aluminum, and beryllium.

In some embodiments, the piezoelectric layer 306 is a flat layer and also covers the intermediate layer 302 at the upper surface side. In some embodiments, the piezoelectric layer 306 is made of one or more materials selected from but not limited to a group consisting of aluminum nitride, aluminum nitride alloy, gallium nitride, zinc oxide, lithium tantalate, lithium niobate, lead zirconate titanate, and lead magnesium niobate-lead titanate.

In some embodiments, the piezoelectric layer 306 includes multiple crystal grains, the crystal grains include a first crystal grain and a second crystal grain, and the first crystal grain and the second crystal grain are any two crystal grains of the crystal grains. Those skilled in the art know that crystallographic orientation, crystal planes and the like can be represented based on a coordinate system. As shown in FIG. 3b, for crystal grains of a hexagonal crystal system, such as an aluminum nitride crystal grain, may be represented by an ac stereoscopic coordinate system (including a-axis and c-axis). As shown in FIG. 3c, the crystal grains of (i) orthorhombic system (a ≠ b ≠ c), (ii) tetragonal system (a = b ≠c), (iii) cubic system (a = b = c), etc., may be represented by an xyz stereoscopic coordinate system (including x-axis, y-axis and z-axis). In addition to the two embodiments described above, crystal grains may also be represented based on other coordinate systems known to those skilled in the art, and therefore the present disclosure is not limited by the two embodiments described above.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction is within a range from 0 degree to 5 degrees, and the first direction being opposite to the second direction means that the included angle between the vector along the first direction and the vector along the second direction is within a range from 175 degrees to 180 degrees.

In some embodiments, the first stereoscopic coordinate system is an ac stereoscopic coordinate system, and the first coordinate axis is a first c-axis and the third coordinate axis is a first a-axis. The second stereoscopic coordinate system is an ac stereoscopic coordinate system, and the second coordinate axis is a second c-axis, and the fourth coordinate axis is a second a-axis. The first c-axis and the second c-axis have the same orientation or opposite orientations.

In some embodiments, the first stereoscopic coordinate system further includes a fifth coordinate axis along a fifth direction, and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction is within a range from 0 degree to 5 degrees, and the third direction being opposite to the fourth direction means that the included angle between the vector along the third direction and the vector along the fourth direction is within a range from 175 degrees to 180 degrees.

In some embodiments, the first stereoscopic coordinate system is an xyz stereoscopic coordinate system, and the first coordinate axis is a first z-axis, the third coordinate axis is a first y-axis, and the fifth coordinate axis is a first x-axis. The second stereoscopic coordinate system is an xyz stereoscopic coordinate system, and the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientations, and the first y-axis and the second y-axis have opposite orientations. In some embodiments, the first z-axis and the second z-axis have the same orientation, and the first y-axis and the second y-axis have opposite orientations. In some embodiments, the first z-axis and the second z-axis have opposite orientations, and the first y-axis and the second y-axis have the same orientation.

In some embodiments, the piezoelectric layer 306 includes crystal grains, and a crystal composed of crystal grains has a full width at half maximum of a rocking curve less than 2.5 degrees. It should be noted that the rocking curve describes a magnitude of angular divergence of a particular crystal plane (a crystal plane determined by a diffraction angle) in a sample, which is represented by a plane coordinate system, and an abscissa represents an angle between the crystal plane and a sample plane, and an ordinate represents a diffraction intensity of the crystal plane at an angle. The rocking curve represents a crystal quality, and the smaller the full width at half maximum of the rocking curve is, the better the crystal quality is. In addition, the Full Width at Half Maximum (FWHM) refers to an interval between two points whose function values equal to a half of a peak value of the function.

It should be noted that the piezoelectric layer 306 formed on a planar surface may not include a crystal grain that is turned significantly, thereby increasing the electromechanical coupling coefficient and the Q value of the resonance device.

In some embodiments, the electrode layer 307 is made of one or more materials selected from but not limited to a group consisting of molybdenum, ruthenium, tungsten, platinum, iridium, aluminum, and beryllium.

In some embodiments, a part of the electrode layer 305 that overlaps with the electrode layer 307 is disposed in the cavity 303; and a part of the electrode 307 that overlaps with the electrode 305 is disposed above the cavity 303.

In some embodiments, the edge structure 308 is made of a material including metal. In some embodiments, the edge structure 308 is made of one or more materials selected from but not limited to a group consisting of molybdenum, ruthenium, tungsten, platinum, iridium, aluminum, and beryllium. In some embodiments, the edge structure 308 and the electrode layer 307 may be made of the same material. In some embodiments, the edge structure above the piezoelectric layer and the upper electrode layer may be made of different materials.

In some embodiments, the edge surrounding part 308a is disposed in the resonance region 309 and forms the surrounding edge of the resonance region 309. It should be noted that, referring to FIG. 3d, an acoustic impedance of an edge part 310 in the resonance region 309 is greater than an acoustic impedance of a middle part 311 in the resonance region 309, and the acoustic impedance of the edge part 310 is greater than the acoustic impedance of the non-resonant region. Therefore, acoustic waves in the transverse mode can be reflected at lateral edges of the resonance region 309 (i.e., the interface between the edge part 310 and the middle part 311 and the interface between the edge part 310 and the non-resonant region) and remain in the resonance region 309, resulting in a raise of the Q value. In order to understand this advantage more intuitively, please refer to FIG. 3e, a quality factor curve 312 represents a normalized Q value of the BAW resonance device without an edge surrounding part, and a quality factor curve 313 represents a normalized Q value of the BAW resonance device including an edge surrounding part (for example, including the edge surrounding part 308a). It should be noted that FIG. 3e is only schematic and is used to understand the advantages of the embodiments of the present disclosure more intuitively, but is not equivalent to actual performances of the BAW resonance device according to the embodiments of the present disclosure.

In some embodiments, a surface at an inner side (i.e., a side directing to a central axis of the resonance device 300) of the edge surrounding part 308a is a straight surface. In some embodiments, a surface at an inner side of the edge surrounding part may be a slope surface.

FIG. 3f schematically illustrates a top-view structural diagram of the bulk acoustic wave resonance device 300 according to some embodiments of the present disclosure.

As shown in FIG. 3f, in some embodiments, the edge surrounding part 308a is in an annular shape. In some embodiments, the edge surrounding part 308a is in an octagonal shape. It should be noted that other shapes of the edge surrounding part known to those skilled in the art, such as hexagons, pentagons, etc., may also be applied to the embodiments of the present disclosure.

FIG. 4a schematically illustrates a structural diagram of a cross-section A of a bulk acoustic wave resonance device 400 according to some embodiments of the present disclosure.

As shown in FIG. 4a, some embodiments of the present disclosure provide a bulk acoustic wave resonance device 400. The bulk acoustic wave resonance device 400 includes: a substrate 401; an intermediate layer 402 disposed on the substrate 401 and including a cavity 403 and a groove 404 disposed at an upper surface side of the intermediate layer 402; an edge structure 405; an electrode layer 406 disposed on the edge structure 405; a piezoelectric layer 407 disposed on the electrode layer 406 and on the intermediate layer 402; and an electrode layer 408. The groove 404 is disposed at one side of the cavity 403 and communicates with the cavity 403, and a depth of the groove 404 is less than a depth of the cavity 403. The edge structure 405 includes an edge surrounding part 405a and an extension part 405b, the edge surrounding part 405a is disposed in the cavity 403, one end of the extension part 405b is connected to the edge surrounding part 405a, and the other end of the extension part 405b is disposed in the groove 404. A first end 406a of the electrode layer 406 is disposed in the cavity 403, a second end 406b of the electrode layer 406 is disposed in the groove 404, and a depth of the groove 404 equals to a sum of a thickness of the edge structure 405 and a thickness of the electrode layer 406. The piezoelectric layer 407 covers the cavity 403 and includes a first side 407a and a second side 407b opposite to the first side 407a. The electrode layer 406 and the intermediate layer 402 are disposed at the first side 407a. The electrode layer 408 is disposed at the second side 407b and on the piezoelectric layer 407. The edge surrounding part 405a is disposed at an edge of an overlap part of the electrode layer 406 and the electrode layer 408.

As shown in FIG. 4a, a resonance region 409 (i.e., the overlap region of the electrode layer 406 and the electrode layer 408) is suspended relative to the cavity 403 and does not overlap with the intermediate layer 402. Therefore, acoustic waves in the transverse mode can be prevented from leaking into the intermediate layer 402 from lateral edges of the resonance region 409, so as to raise the Q value.

In some embodiments, the substrate 401 is made of one or more materials selected from but not limited to a group consisting of silicon, silicon carbide, glass, gallium arsenide, gallium nitride, and ceramic.

In some embodiments, the intermediate layer 402 is made of one or more materials selected from but not limited to a group consisting of polymer, insulating dielectric, and polysilicon. In some embodiments, the polymer includes, but is not limited to, at least one selected from a group consisting of benzocyclobutene (i.e., BCB), photosensitive epoxy resin photoresist (e.g., SU-8), and polyimide. In some embodiments, the insulating dielectric includes, but is not limited to, at least one selected from a group consisting of aluminum nitride, silicon dioxide, silicon nitride, and titanium oxide.

In some embodiments, the edge structure 405 is made of a material including metal. In some embodiments, the edge structure 405 is made of one or more materials selected from but not limited to a group consisting of molybdenum, ruthenium, tungsten, platinum, iridium, aluminum, and beryllium. In some embodiments, the edge structure 405 and the electrode layer 406 may be made of the same material. In some embodiments, the edge structure below the piezoelectric layer and the lower electrode layer may be made of different materials.

In some embodiments, the edge surrounding part 405a is disposed in the resonance region 409 and forms the surrounding edge of the resonance region 409. It should be noted that, an acoustic impedance of an edge part 410 in the resonance region 409 is greater than an acoustic impedance of a middle part 411 in the resonance region 409, and the acoustic impedance of the edge part 410 is greater than the acoustic impedance of the non-resonant region. Therefore, acoustic waves in the transverse mode can be reflected at lateral edges of the resonance region 409 and remain in the resonance region 409, resulting in a raise of the Q value.

In some embodiments, a surface at an inner side (i.e., a side directing to a central axis of the resonance device 400) of the edge surrounding part 405a is a straight surface. In some embodiments, a surface at an inner side of the edge surrounding part may be a slope surface.

In some embodiments, the electrode layer 406 is made of one or more materials selected from but not limited to a group consisting of molybdenum, ruthenium, tungsten, platinum, iridium, aluminum, and beryllium.

In some embodiments, the piezoelectric layer 407 is a flat layer and also covers the intermediate layer 402 at the upper surface side. In some embodiments, the piezoelectric layer 407 is made of one or more materials selected from but not limited to a group consisting of aluminum nitride, aluminum nitride alloy, gallium nitride, zinc oxide, lithium tantalate, lithium niobate, lead zirconate titanate, and lead magnesium niobate-lead titanate.

In some embodiments, the piezoelectric layer 407 includes multiple crystal grains, the crystal grains include a first crystal grain and a second crystal grain, and the first crystal grain and the second crystal grain are any two crystal grains of the crystal grains. Those skilled in the art know that crystallographic orientation, crystal planes and the like can be represented based on a coordinate system.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction is within a range from 0 degree to 5 degrees, and the first direction being opposite to the second direction means that the included angle between the vector along the first direction and the vector along the second direction is within a range from 175 degrees to 180 degrees.

In some embodiments, the first stereoscopic coordinate system is an ac stereoscopic coordinate system, and the first coordinate axis is a first c-axis and the third coordinate axis is a first a-axis. The second stereoscopic coordinate system is an ac stereoscopic coordinate system, and the second coordinate axis is a second c-axis, and the fourth coordinate axis is a second a-axis. The first c-axis and the second c-axis have the same orientation or opposite orientations.

In some embodiments, the first stereoscopic coordinate system further includes a fifth coordinate axis along a fifth direction, and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction is within a range from 0 degree to 5 degrees, and the third direction being opposite to the fourth direction means that the included angle between the vector along the third direction and the vector along the fourth direction is within a range from 175 degrees to 180 degrees.

In some embodiments, the first stereoscopic coordinate system is an xyz stereoscopic coordinate system, and the first coordinate axis is a first z-axis, the third coordinate axis is a first y-axis, and the fifth coordinate axis is a first x-axis. The second stereoscopic coordinate system is an xyz stereoscopic coordinate system, and the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientations, and the first y-axis and the second y-axis have opposite orientations. In some embodiments, the first z-axis and the second z-axis have the same orientation, and the first y-axis and the second y-axis have opposite orientations. In some embodiments, the first z-axis and the second z-axis have opposite orientations, and the first y-axis and the second y-axis have the same orientation.

In some embodiments, the piezoelectric layer 407 includes crystal grains, and a crystal composed of crystal grains has a full width at half maximum of a rocking curve less than 2.5 degrees.

It should be noted that the piezoelectric layer 407 formed on a planar surface may not include a crystal grain that is turned significantly, thereby increasing the electromechanical coupling coefficient and the Q value of the resonance device.

In some embodiments, the electrode layer 408 is made of one or more materials selected from but not limited to a group consisting of molybdenum, ruthenium, tungsten, platinum, iridium, aluminum, and beryllium.

In some embodiments, a part of the electrode layer 406 that overlaps with the electrode layer 408 is disposed in the cavity 403; and a part of the electrode 408 that overlaps with the electrode 406 is disposed above the cavity 403.

FIG. 4b schematically illustrates a top-view structural diagram of the bulk acoustic wave resonance device 400 according to some embodiments of the present disclosure.

As shown in FIG. 4b, in some embodiments, the edge surrounding part 405a is in an annular shape. In some embodiments, the edge surrounding part 405a is in an octagonal shape. It should be noted that other shapes of the edge surrounding part known to those skilled in the art, such as hexagons, pentagons, etc., may also be applied to the embodiments of the present disclosure.

FIG. 5a schematically illustrates a structural diagram of a cross-section A of a bulk acoustic wave resonance device 500 according to some embodiments of the present disclosure.

As shown in FIG. 5a, some embodiments of the present disclosure provide a bulk acoustic wave resonance device 500. The bulk acoustic wave resonance device 500 includes: a substrate 501; an intermediate layer 502 disposed on the substrate 501 and including a cavity 503 and a groove 504 disposed at an upper surface side of the intermediate layer 502; an edge structure 505; an electrode layer 506 disposed on the edge structure 505; a piezoelectric layer 507 disposed on the electrode layer 506 and on the intermediate layer 502; an electrode layer 508; and an edge structure 509. The groove 504 is disposed at one side of the cavity 503 and communicates with the cavity 503, and a depth of the groove 504 is less than a depth of the cavity 503. The edge structure 505 includes an edge surrounding part 505a and an extension part 505b, the edge surrounding part 505a is disposed in the cavity 503, one end of the extension part 505b is connected to the edge surrounding part 505a, and the other end of the extension part 505b is disposed in the groove 504. A first end 506a of the electrode layer 506 is disposed in the cavity 503, a second end 506b of the electrode layer 506 is disposed in the groove 504, and a depth of the groove 504 equals to a sum of a thickness of the edge structure 505 and a thickness of the electrode layer 506. The piezoelectric layer 507 covers the cavity 503 and includes a first side 507a and a second side 507b opposite to the first side 507a. The electrode layer 506 and the intermediate layer 502 are disposed at the first side 507a. The electrode layer 508 is disposed at the second side 507b and on the piezoelectric layer 507. The edge surrounding part 505a is disposed at a part of an edge of an overlap part of the electrode layer 506 and the electrode layer 508. The edge structure 509 is disposed at the second side 507b and on the electrode layer 508, and the piezoelectric layer 507 and the edge structure 509 are respectively disposed at both sides of the electrode layer 508. The edge structure 509 includes an edge surrounding part 509a disposed at a part of the edge of the overlap part of the electrode layer 508 and the electrode layer 506. The edge surrounding part 505a and the edge surrounding part 509a partially overlap to form a surrounding edge.

As shown in FIG. 5a, a resonance region 510 (i.e., the overlap region of the electrode layer 506 and the electrode layer 508) is suspended relative to the cavity 503 and does not overlap with the intermediate layer 502. Therefore, acoustic waves in the transverse mode can be prevented from leaking into the intermediate layer 502 from lateral edges of the resonance region 510, so as to raise the Q value.

In some embodiments, the substrate 501 is made of one or more materials selected from but not limited to a group consisting of silicon, silicon carbide, glass, gallium arsenide, gallium nitride, and ceramic.

In some embodiments, the intermediate layer 502 is made of one or more materials selected from but not limited to a group consisting of polymer, insulating dielectric, and polysilicon. In some embodiments, the polymer includes, but is not limited to, at least one selected from a group consisting of benzocyclobutene (i.e., BCB), photosensitive epoxy resin photoresist (e.g., SU-8), and polyimide. In some embodiments, the insulating dielectric includes, but is not limited to, at least one selected from a group consisting of aluminum nitride, silicon dioxide, silicon nitride, and titanium oxide.

In some embodiments, the edge structure 505 is made of a material including metal. In some embodiments, the edge structure 505 is made of one or more materials selected from but not limited to a group consisting of molybdenum, ruthenium, tungsten, platinum, iridium, aluminum, and beryllium. In some embodiments, the edge structure 505 and the electrode layer 506 may be made of the same material. In some embodiments, a first edge structure below the piezoelectric layer and the lower electrode layer may be made of different materials.

In some embodiments, the electrode layer 506 is made of one or more materials selected from but not limited to a group consisting of molybdenum, ruthenium, tungsten, platinum, iridium, aluminum, and beryllium.

In some embodiments, the piezoelectric layer 507 is a flat layer and also covers the intermediate layer 502 at the upper surface side. In some embodiments, the piezoelectric layer 507 is made of one or more materials selected from but not limited to a group consisting of aluminum nitride, aluminum nitride alloy, gallium nitride, zinc oxide, lithium tantalate, lithium niobate, lead zirconate titanate, and lead magnesium niobate-lead titanate.

In some embodiments, the piezoelectric layer 507 includes multiple crystal grains, the crystal grains include a first crystal grain and a second crystal grain, and the first crystal grain and the second crystal grain are any two crystal grains of the crystal grains. Those skilled in the art know that crystallographic orientation, crystal planes and the like can be represented based on a coordinate system.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction is within a range from 0 degree to 5 degrees, and the first direction being opposite to the second direction means that the included angle between the vector along the first direction and the vector along the second direction is within a range from 175 degrees to 180 degrees.

In some embodiments, the first stereoscopic coordinate system is an ac stereoscopic coordinate system, and the first coordinate axis is a first c-axis and the third coordinate axis is a first a-axis. The second stereoscopic coordinate system is an ac stereoscopic coordinate system, and the second coordinate axis is a second c-axis, and the fourth coordinate axis is a second a-axis. The first c-axis and the second c-axis have the same orientation or opposite orientations.

In some embodiments, the first stereoscopic coordinate system further includes a fifth coordinate axis along a fifth direction, and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction is within a range from 0 degree to 5 degrees, and the third direction being opposite to the fourth direction means that the included angle between the vector along the third direction and the vector along the fourth direction is within a range from 175 degrees to 180 degrees.

In some embodiments, the first stereoscopic coordinate system is an xyz stereoscopic coordinate system, and the first coordinate axis is a first z-axis, the third coordinate axis is a first y-axis, and the fifth coordinate axis is a first x-axis. The second stereoscopic coordinate system is an xyz stereoscopic coordinate system, and the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientations, and the first y-axis and the second y-axis have opposite orientations. In some embodiments, the first z-axis and the second z-axis have the same orientation, and the first y-axis and the second y-axis have opposite orientations. In some embodiments, the first z-axis and the second z-axis have opposite orientations, and the first y-axis and the second y-axis have the same orientation.

In some embodiments, the piezoelectric layer 507 includes crystal grains, and a crystal composed of crystal grains has a full width at half maximum of a rocking curve less than 2.5 degrees.

It should be noted that the piezoelectric layer 507 formed on a planar surface may not include a crystal grain that is turned significantly, thereby increasing the electromechanical coupling coefficient and the Q value of the resonance device.

In some embodiments, the electrode layer 508 is made of one or more materials selected from but not limited to a group consisting of molybdenum, ruthenium, tungsten, platinum, iridium, aluminum, and beryllium.

In some embodiments, a part of the electrode layer 506 that overlaps with the electrode layer 508 is disposed in the cavity 503; and a part of the electrode 508 that overlaps with the electrode 506 is disposed above the cavity 503.

In some embodiments, the edge structure 509 is made of a material including metal. In some embodiments, the edge structure 509 is made of one or more materials selected from but not limited to a group consisting of molybdenum, ruthenium, tungsten, platinum, iridium, aluminum, and beryllium. In some embodiments, the edge structure 509 and the electrode layer 508 may be made of the same material. In some embodiments, a second edge structure above the piezoelectric layer and the upper electrode layer may be made of different materials.

In some embodiments, the edge surrounding part 505a is disposed in the resonance region 510, the edge surrounding part 509a is disposed in the resonance region 510, and the edge surrounding part 505a and the edge surrounding part 509a partially overlap to form the surrounding edge of the resonance region 510. It should be noted that, an acoustic impedance of an edge part 511 in the resonance region 510 is greater than an acoustic impedance of a middle part 512 in the resonance region 510, and the acoustic impedance of the edge part 511 is greater than the acoustic impedance of the non-resonant region. Therefore, acoustic waves in the transverse mode can be reflected at lateral edges of the resonance region 510 and remain in the resonance region 510, resulting in a raise of the Q value.

In some embodiments, a surface at an inner side (i.e., a side directing to a central axis of the resonance device 500) of the edge surrounding part 505a is a straight surface, and a surface at an inner side of the edge surrounding part 509a is a straight surface. In some embodiments, a surface at an inner side of the edge surrounding parts may be a slope surface.

FIG. 5b schematically illustrates a top-view structural diagram of the bulk acoustic wave resonance device 500 according to some embodiments of the present disclosure.

As shown in FIG. 5b, in some embodiments, the edge surrounding part 505a has an overlap part 513 with the edge surrounding part 509a, forming a surrounding edge of the resonance region 510 and thus can prevent leakage of transverse waves. In some embodiments, the surrounding edge formed by the edge surrounding part 505a and the edge surrounding part 509a is in an annular shape. In some embodiments, the surrounding edge formed by the edge surrounding part 505a and the edge surrounding part 509a is in an octagonal shape. It should be noted that other shapes of the edge surrounding part known to those skilled in the art, such as hexagons, pentagons, etc., may also be applied to the embodiments of the present disclosure.

FIG. 5c schematically illustrates a structural diagram of a cross-section B of the bulk acoustic wave resonance device 500 according to some embodiments of the present disclosure. FIG. 5c illustrates a structure of a cross-section B of the overlap part 513.

FIG. 6 schematically illustrates a structural diagram of a cross-section A of a bulk acoustic wave resonance device 600 according to some embodiments of the present disclosure.

As shown in FIG. 6, some embodiments of the present disclosure provide a bulk acoustic wave resonance device 600. The bulk acoustic wave resonance device 600 includes: a substrate 601; an intermediate layer 602 disposed on the substrate 601 and including a cavity 603 and a groove 604 disposed at an upper surface side of the intermediate layer 602; an edge structure 605; an electrode layer 606 disposed on the edge structure 605; a piezoelectric layer 607 disposed on the electrode layer 606 and on the intermediate layer 602; an electrode layer 608; and an edge structure 609. The groove 604 is disposed at one side of the cavity 603 and communicates with the cavity 603, and a depth of the groove 604 is less than a depth of the cavity 603. The edge structure 605 includes an edge surrounding part 605a and an extension part 605b, the edge surrounding part 605a is disposed in the cavity 603, one end of the extension part 605b is connected to the edge surrounding part 605a, and the other end of the extension part 605b is disposed in the groove 604. A first end 606a of the electrode layer 606 is disposed in the cavity 603, a second end 606b of the electrode layer 606 is disposed in the groove 604, and a depth of the groove 604 equals to a sum of a thickness of the edge structure 605 and a thickness of the electrode layer 606. The piezoelectric layer 607 covers the cavity 603 and includes a first side 607a and a second side 607b opposite to the first side 607a. The electrode layer 606 and the intermediate layer 602 are disposed at the first side 607a. The electrode layer 608 is disposed at the second side 607b and on the piezoelectric layer 607. The edge surrounding part 605a is disposed at an edge of an overlap part of the electrode layer 606 and the electrode layer 608. The edge structure 609 is disposed at the second side 607b and on the electrode layer 608, and the piezoelectric layer 607 and the edge structure 609 are respectively disposed at both sides of the electrode layer 608. The edge structure 609 includes an edge surrounding part 609a disposed at the edge of the overlap part of the electrode layer 606 and the electrode layer 608. The edge surrounding part 605a and the edge surrounding part 609a overlap to form a surrounding edge.

As shown in FIG. 6a, a resonance region 610 (i.e., the overlap region of the electrode layer 606 and the electrode layer 608) is suspended relative to the cavity 603 and does not overlap with the intermediate layer 602. Therefore, acoustic waves in the transverse mode can be prevented from leaking into the intermediate layer 602 from lateral edges of the resonance region 610, so as to raise the Q value.

In some embodiments, the substrate 601 is made of one or more materials selected from but not limited to a group consisting of silicon, silicon carbide, glass, gallium arsenide, gallium nitride, and ceramic.

In some embodiments, the intermediate layer 602 is made of one or more materials selected from but not limited to a group consisting of polymer, insulating dielectric, and polysilicon. In some embodiments, the polymer includes, but is not limited to, at least one selected from a group consisting of benzocyclobutene (i.e., BCB), photosensitive epoxy resin photoresist (e.g., SU-8), and polyimide. In some embodiments, the insulating dielectric includes, but is not limited to, at least one selected from a group consisting of aluminum nitride, silicon dioxide, silicon nitride, and titanium oxide.

In some embodiments, the edge structure 605 is made of a material including metal. In some embodiments, the edge structure 605 is made of one or more materials selected from but not limited to a group consisting of molybdenum, ruthenium, tungsten, platinum, iridium, aluminum, and beryllium. In some embodiments, the edge structure 605 and the electrode layer 606 may be made of the same material. In some embodiments, a first edge structure below the piezoelectric layer and the lower electrode layer may be made of different materials.

In some embodiments, the electrode layer 606 is made of one or more materials selected from but not limited to a group consisting of molybdenum, ruthenium, tungsten, platinum, iridium, aluminum, and beryllium.

In some embodiments, the piezoelectric layer 607 is a flat layer and also covers the intermediate layer 602 at the upper surface side. In some embodiments, the piezoelectric layer 607 is made of one or more materials selected from but not limited to a group consisting of aluminum nitride, aluminum nitride alloy, gallium nitride, zinc oxide, lithium tantalate, lithium niobate, lead zirconate titanate, and lead magnesium niobate-lead titanate.

In some embodiments, the piezoelectric layer 607 includes multiple crystal grains, the crystal grains include a first crystal grain and a second crystal grain, and the first crystal grain and the second crystal grain are any two crystal grains of the crystal grains. Those skilled in the art know that crystallographic orientation, crystal planes and the like can be represented based on a coordinate system.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction is within a range from 0 degree to 5 degrees, and the first direction being opposite to the second direction means that the included angle between the vector along the first direction and the vector along the second direction is within a range from 175 degrees to 180 degrees.

In some embodiments, the first stereoscopic coordinate system is an ac stereoscopic coordinate system, and the first coordinate axis is a first c-axis and the third coordinate axis is a first a-axis. The second stereoscopic coordinate system is an ac stereoscopic coordinate system, and the second coordinate axis is a second c-axis, and the fourth coordinate axis is a second a-axis. The first c-axis and the second c-axis have the same orientation or opposite orientations.

In some embodiments, the first stereoscopic coordinate system further includes a fifth coordinate axis along a fifth direction, and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction is within a range from 0 degree to 5 degrees, and the third direction being opposite to the fourth direction means that the included angle between the vector along the third direction and the vector along the fourth direction is within a range from 175 degrees to 180 degrees.

In some embodiments, the first stereoscopic coordinate system is an xyz stereoscopic coordinate system, and the first coordinate axis is a first z-axis, the third coordinate axis is a first y-axis, and the fifth coordinate axis is a first x-axis. The second stereoscopic coordinate system is an xyz stereoscopic coordinate system, and the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientations, and the first y-axis and the second y-axis have opposite orientations. In some embodiments, the first z-axis and the second z-axis have the same orientation, and the first y-axis and the second y-axis have opposite orientations. In some embodiments, the first z-axis and the second z-axis have opposite orientations, and the first y-axis and the second y-axis have the same orientation.

In some embodiments, the piezoelectric layer 607 includes crystal grains, and a crystal composed of crystal grains has a full width at half maximum of a rocking curve less than 2.5 degrees.

It should be noted that the piezoelectric layer 607 formed on a planar surface may not include a crystal grain that is turned significantly, thereby increasing the electromechanical coupling coefficient and the Q value of the resonance device.

In some embodiments, the electrode layer 608 is made of one or more materials selected from but not limited to a group consisting of molybdenum, ruthenium, tungsten, platinum, iridium, aluminum, and beryllium.

In some embodiments, a part of the electrode layer 606 that overlaps with the electrode layer 608 is disposed in the cavity 603; and a part of the electrode 608 that overlaps with the electrode 606 is disposed above the cavity 603.

In some embodiments, the edge structure 609 is made of a material including metal. In some embodiments, the edge structure 609 is made of one or more materials selected from but not limited to a group consisting of molybdenum, ruthenium, tungsten, platinum, iridium, aluminum, and beryllium. In some embodiments, the edge structure 609 and the electrode layer 608 may be made of the same material. In some embodiments, a second edge structure above the piezoelectric layer and the upper electrode layer may be made of different materials.

In some embodiments, the edge surrounding part 605a is disposed in the resonance region 610, the edge surrounding part 609a is disposed in the resonance region 610, and the edge surrounding part 605a and the edge surrounding part 609a overlap to form the surrounding edge of the resonance region 610. It should be noted that, an acoustic impedance of an edge part 611 in the resonance region 610 is greater than an acoustic impedance of a middle part 612 in the resonance region 610, and the acoustic impedance of the edge part 611 is greater than the acoustic impedance of the non-resonant region. Therefore, acoustic waves in the transverse mode can be reflected at lateral edges of the resonance region 610 and remain in the resonance region 610, resulting in a raise of the Q value.

In some embodiments, a surface at an inner side (i.e., a side directing to a central axis of the resonance device 600) of the edge surrounding part 605a is a straight surface, and a surface at an inner side of the edge surrounding part 609a is a straight surface. In some embodiments, a surface at an inner side of the edge surrounding parts may be a slope surface.

FIG. 7 schematically illustrates a structural diagram of a cross-section A of a bulk acoustic wave resonance device 700 according to some embodiments of the present disclosure.

As shown in FIG. 7, some embodiments of the present disclosure provide a bulk acoustic wave resonance device 700. The bulk acoustic wave resonance device 700 includes: a substrate 701; an intermediate layer 702 disposed on the substrate 701 and including a cavity 703 and a groove 704 disposed at an upper surface side of the intermediate layer 702; an electrode layer 705; a piezoelectric layer 706 disposed on the electrode layer 705 and on the intermediate layer 702; an electrode layer 707; and an edge structure 708. The groove 704 is disposed at one side of the cavity 703 and communicates with the cavity 703, and a depth of the groove 704 is less than a depth of the cavity 703. The electrode layer 705 includes a first end 705a disposed in the cavity 703 and a second end 705b disposed in the groove 704, and a depth of the groove 704 equals to a thickness of the electrode layer 705. The piezoelectric layer 706 covers the cavity 703 and includes a first side 706a and a second side 706b opposite to the first side 706a. The electrode layer 705 and the intermediate layer 702 are disposed at the first side 706a. The electrode layer 707 is disposed at the second side 706b and on the piezoelectric layer 706. The edge structure 708 is disposed at the second side 706b and on the piezoelectric layer 706, and the edge structure 708 includes an edge surrounding part 708a. The electrode layer 707 is disposed inside the edge surrounding part 708a (i.e., an inner side directing to a central axis of the resonance device 700), and the edge surrounding part 708a overlaps with the electrode layer 705.

As shown in FIG. 7, a resonance region 709 (i.e., the overlap region that the electrode layer 705 overlaps with the electrode layer 707 and the edge surrounding part 708a) is suspended relative to the cavity 703 and does not overlap with the intermediate layer 702. Therefore, acoustic waves in the transverse mode can be prevented from leaking into the intermediate layer 702 from lateral edges of the resonance region 709, so as to raise the Q value.

In some embodiments, the substrate 701 is made of one or more materials selected from but not limited to a group consisting of silicon, silicon carbide, glass, gallium arsenide, gallium nitride, and ceramic.

In some embodiments, the intermediate layer 702 is made of one or more materials selected from but not limited to a group consisting of polymer, insulating dielectric, and polysilicon. In some embodiments, the polymer includes, but is not limited to, at least one selected from a group consisting of benzocyclobutene (i.e., BCB), photosensitive epoxy resin photoresist (e.g., SU-8), and polyimide. In some embodiments, the insulating dielectric includes, but is not limited to, at least one selected from a group consisting of aluminum nitride, silicon dioxide, silicon nitride, and titanium oxide.

In some embodiments, the electrode layer 705 is made of one or more materials selected from but not limited to a group consisting of molybdenum, ruthenium, tungsten, platinum, iridium, aluminum, and beryllium.

In some embodiments, the piezoelectric layer 706 is a flat layer and also covers the intermediate layer 702 at the upper surface side. In some embodiments, the piezoelectric layer 706 is made of one or more materials selected from but not limited to a group consisting of aluminum nitride, aluminum nitride alloy, gallium nitride, zinc oxide, lithium tantalate, lithium niobate, lead zirconate titanate, and lead magnesium niobate-lead titanate.

In some embodiments, the piezoelectric layer 706 includes multiple crystal grains, the crystal grains include a first crystal grain and a second crystal grain, and the first crystal grain and the second crystal grain are any two crystal grains of the crystal grains. Those skilled in the art know that crystallographic orientation, crystal planes and the like can be represented based on a coordinate system.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction is within a range from 0 degree to 5 degrees, and the first direction being opposite to the second direction means that the included angle between the vector along the first direction and the vector along the second direction is within a range from 175 degrees to 180 degrees.

In some embodiments, the first stereoscopic coordinate system is an ac stereoscopic coordinate system, and the first coordinate axis is a first c-axis and the third coordinate axis is a first a-axis. The second stereoscopic coordinate system is an ac stereoscopic coordinate system, and the second coordinate axis is a second c-axis, and the fourth coordinate axis is a second a-axis. The first c-axis and the second c-axis have the same orientation or opposite orientations.

In some embodiments, the first stereoscopic coordinate system further includes a fifth coordinate axis along a fifth direction, and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction is within a range from 0 degree to 5 degrees, and the third direction being opposite to the fourth direction means that the included angle between the vector along the third direction and the vector along the fourth direction is within a range from 175 degrees to 180 degrees.

In some embodiments, the first stereoscopic coordinate system is an xyz stereoscopic coordinate system, and the first coordinate axis is a first z-axis, the third coordinate axis is a first y-axis, and the fifth coordinate axis is a first x-axis. The second stereoscopic coordinate system is an xyz stereoscopic coordinate system, and the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientations, and the first y-axis and the second y-axis have opposite orientations. In some embodiments, the first z-axis and the second z-axis have the same orientation, and the first y-axis and the second y-axis have opposite orientations. In some embodiments, the first z-axis and the second z-axis have opposite orientations, and the first y-axis and the second y-axis have the same orientation.

In some embodiments, the piezoelectric layer 706 includes crystal grains, and a crystal composed of crystal grains has a full width at half maximum of a rocking curve less than 2.5 degrees.

It should be noted that the piezoelectric layer 706 formed on a planar surface may not include a crystal grain that is turned significantly, thereby increasing the electromechanical coupling coefficient and the Q value of the resonance device.

In some embodiments, the electrode layer 707 is made of one or more materials selected from but not limited to a group consisting of molybdenum, ruthenium, tungsten, platinum, iridium, aluminum, and beryllium.

In some embodiments, a part of the electrode layer 705 that overlaps with the electrode layer 707 is disposed in the cavity 703; and a part of the electrode 707 that overlaps with the electrode 705 is disposed above the cavity 703.

In some embodiments, the edge structure 708 is made of a material including metal. In some embodiments, the edge structure 708 is made of one or more materials selected from but not limited to a group consisting of molybdenum, ruthenium, tungsten, platinum, iridium, aluminum, and beryllium. In some embodiments, the edge structure 708 and the electrode layer 707 may be made of the same material. In some embodiments, the edge structure on the piezoelectric layer and the upper electrode layer may be made of different materials.

In some embodiments, a thickness of the edge structure 708 is greater than a thickness of the electrode layer 707. In some embodiments, a thickness of the edge structure on the piezoelectric layer is less than a thickness of the upper electrode layer. In some embodiments, a thickness of the edge structure on the piezoelectric layer equals to a thickness of the upper electrode layer.

In some embodiments, the edge surrounding part 708a is disposed in the resonance region 709 and forms the surrounding edge of the resonance region 709. It should be noted that, an acoustic impedance of an edge part 710 in the resonance region 709 is greater than an acoustic impedance of a middle part 711 in the resonance region 709, and the acoustic impedance of the edge part 710 is greater than the acoustic impedance of the non-resonant region. Therefore, acoustic waves in the transverse mode can be reflected at lateral edges of the resonance region 709 and remain in the resonance region 709, resulting in a raise of the Q value.

In some embodiments, a surface at an inner side of the edge surrounding part 708a is a straight surface. In some embodiments, a surface at an inner side of the edge surrounding part may be a slope surface.

FIG. 8 schematically illustrates a structural diagram of a cross-section A of a bulk acoustic wave resonance device 800 according to some embodiments of the present disclosure.

As shown in FIG. 8, some embodiments of the present disclosure provide a bulk acoustic wave resonance device 800. The bulk acoustic wave resonance device 800 includes: a substrate 801; an intermediate layer 802 disposed on the substrate 801 and including a cavity 803 and a groove 804 disposed at an upper surface side of the intermediate layer 802; an electrode layer 805 disposed in the cavity 803; an edge structure 806; a piezoelectric layer 807 disposed on the electrode layer 805, on the edge structure 806, and on the intermediate layer 802; and an electrode layer 808. The groove 804 is disposed at one side of the cavity 803 and communicates with the cavity 803, and a depth of the groove 804 is less than a depth of the cavity 803. The edge structure 806 includes an edge surrounding part 806a and an extension part 806b, and the edge surrounding part 806a is disposed in the cavity 803. The electrode layer 805 is disposed inside the edge surrounding part 806a (i.e., an inner side directing to a central axis of the resonance device 800). One end of the extension part 806b is connected to the edge surrounding part 806a, and the other end of the extension part 806b is disposed in the groove 804. A depth of the groove 804 equals to a thickness of the edge structure 806. The piezoelectric layer 807 covers the cavity 803 and includes a first side 807a and a second side 807b opposite to the first side 807a. The electrode layer 805, the edge structure 806 and the intermediate layer 802 are disposed at the first side 807a. The electrode layer 808 is disposed at the second side 807b and on the piezoelectric layer 807. The edge surrounding part 806a overlaps with the electrode layer 808.

As shown in FIG. 8, a resonance region 809 (i.e., the overlap region that the edge surrounding part 806a and the electrode layer 805 overlap with the electrode layer 808) is suspended relative to the cavity 803 and does not overlap with the intermediate layer 802. Therefore, acoustic waves in the transverse mode can be prevented from leaking into the intermediate layer 802 from lateral edges of the resonance region 809, so as to raise the Q value.

In some embodiments, the substrate 801 is made of one or more materials selected from but not limited to a group consisting of silicon, silicon carbide, glass, gallium arsenide, gallium nitride, and ceramic.

In some embodiments, the intermediate layer 802 is made of one or more materials selected from but not limited to a group consisting of polymer, insulating dielectric, and polysilicon. In some embodiments, the polymer includes, but is not limited to, at least one selected from a group consisting of benzocyclobutene (i.e., BCB), photosensitive epoxy resin photoresist (e.g., SU-8), and polyimide. In some embodiments, the insulating dielectric includes, but is not limited to, at least one selected from a group consisting of aluminum nitride, silicon dioxide, silicon nitride, and titanium oxide.

In some embodiments, the electrode layer 805 is made of one or more materials selected from but not limited to a group consisting of molybdenum, ruthenium, tungsten, platinum, iridium, aluminum, and beryllium.

In some embodiments, the edge structure 806 is made of a material including metal. In some embodiments, the edge structure 806 is made of one or more materials selected from but not limited to a group consisting of molybdenum, ruthenium, tungsten, platinum, iridium, aluminum, and beryllium. In some embodiments, the edge structure 806 and the electrode layer 805 may be made of the same material. In some embodiments, the edge structure below the piezoelectric layer and the lower electrode layer may be made of different materials.

In some embodiments, a thickness of the edge structure 806 is greater than a thickness of the electrode layer 805. In some embodiments, a thickness of the edge structure below the piezoelectric layer is less than a thickness of the lower electrode layer. In some embodiments, a thickness of the edge structure below the piezoelectric layer equals to a thickness of the lower electrode layer.

In some embodiments, the edge surrounding part 806a is disposed in the resonance region 809 and forms the surrounding edge of the resonance region 809. It should be noted that, an acoustic impedance of an edge part 810 in the resonance region 809 is greater than an acoustic impedance of a middle part 811 in the resonance region 809, and the acoustic impedance of the edge part 810 is greater than the acoustic impedance of the non-resonant region. Therefore, acoustic waves in the transverse mode can be reflected at lateral edges of the resonance region 809 and remain in the resonance region 809, resulting in a raise of the Q value.

In some embodiments, a surface at an inner side of the edge surrounding part 806a is a straight surface. In some embodiments, a surface at an inner side of the edge surrounding part may be a slope surface.

In some embodiments, the piezoelectric layer 807 is a flat layer and also covers the intermediate layer 802 at the upper surface side. In some embodiments, the piezoelectric layer 807 is made of one or more materials selected from but not limited to a group consisting of aluminum nitride, aluminum nitride alloy, gallium nitride, zinc oxide, lithium tantalate, lithium niobate, lead zirconate titanate, and lead magnesium niobate-lead titanate.

In some embodiments, the piezoelectric layer 807 includes multiple crystal grains, the crystal grains include a first crystal grain and a second crystal grain, and the first crystal grain and the second crystal grain are any two crystal grains of the crystal grains. Those skilled in the art know that crystallographic orientation, crystal planes and the like can be represented based on a coordinate system.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction is within a range from 0 degree to 5 degrees, and the first direction being opposite to the second direction means that the included angle between the vector along the first direction and the vector along the second direction is within a range from 175 degrees to 180 degrees.

In some embodiments, the first stereoscopic coordinate system is an ac stereoscopic coordinate system, and the first coordinate axis is a first c-axis and the third coordinate axis is a first a-axis. The second stereoscopic coordinate system is an ac stereoscopic coordinate system, and the second coordinate axis is a second c-axis, and the fourth coordinate axis is a second a-axis. The first c-axis and the second c-axis have the same orientation or opposite orientations.

In some embodiments, the first stereoscopic coordinate system further includes a fifth coordinate axis along a fifth direction, and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction is within a range from 0 degree to 5 degrees, and the third direction being opposite to the fourth direction means that the included angle between the vector along the third direction and the vector along the fourth direction is within a range from 175 degrees to 180 degrees.

In some embodiments, the first stereoscopic coordinate system is an xyz stereoscopic coordinate system, and the first coordinate axis is a first z-axis, the third coordinate axis is a first y-axis, and the fifth coordinate axis is a first x-axis. The second stereoscopic coordinate system is an xyz stereoscopic coordinate system, and the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientations, and the first y-axis and the second y-axis have opposite orientations. In some embodiments, the first z-axis and the second z-axis have the same orientation, and the first y-axis and the second y-axis have opposite orientations. In some embodiments, the first z-axis and the second z-axis have opposite orientations, and the first y-axis and the second y-axis have the same orientation.

In some embodiments, the piezoelectric layer 807 includes crystal grains, and a crystal composed of crystal grains has a full width at half maximum of a rocking curve less than 2.5 degrees.

It should be noted that the piezoelectric layer 807 formed on a planar surface may not include a crystal grain that is turned significantly, thereby increasing the electromechanical coupling coefficient and the Q value of the resonance device.

In some embodiments, the electrode layer 808 is made of one or more materials selected from but not limited to a group consisting of molybdenum, ruthenium, tungsten, platinum, iridium, aluminum, and beryllium.

In some embodiments, a part of the electrode layer 805 that overlaps with the electrode layer 808 is disposed in the cavity 703; and a part of the electrode 808 that overlaps with the electrode 805 is disposed above the cavity 803.

FIG. 9a schematically illustrates a structural diagram of a cross-section A of a bulk acoustic wave resonance device 900 according to some embodiments of the present disclosure.

As shown in FIG. 9a, some embodiments of the present disclosure provide a bulk acoustic wave resonance device 900. The bulk acoustic wave resonance device 900 includes: a substrate 901; an intermediate layer 902 disposed on the substrate 901 and including a cavity 903 and a groove 904 disposed at an upper surface side of the intermediate layer 902; an electrode layer 905 disposed in the cavity 903; an edge structure 906; a piezoelectric layer 907 disposed on the electrode layer 905, on the edge structure 906, and on the intermediate layer 902; an electrode layer 908; and an edge structure 909. The groove 904 is disposed at one side of the cavity 903 and communicates with the cavity 903, and a depth of the groove 904 is less than a depth of the cavity 903. The edge structure 906 includes an edge surrounding part 906a and an extension part 906b. The edge surrounding part 906a is disposed in the cavity 903 and disposed beside a part of an edge of the electrode layer 905. The electrode layer 905 is disposed at an inner side (i.e., a side directing to a central axis of the resonance device 900) of the edge surrounding part 906a. One end of the extension part 906b is connected to the edge surrounding part 906a, and the other end of the extension part 906b is disposed in the groove 904. A depth of the groove 904 equals to a thickness of the edge structure 906. The piezoelectric layer 907 covers the cavity 903 and includes a first side 907a and a second side 907b opposite to the first side 907a. The electrode layer 905, the edge structure 906 and the intermediate layer 902 are disposed at the first side 907a. The electrode layer 908 is disposed at the second side 907b and on the piezoelectric layer 907. The edge surrounding part 906a overlaps with the electrode layer 908. The edge structure 909 is disposed at the second side 907b and on the piezoelectric layer 907, and the edge structure 909 includes an edge surrounding part 909a disposed beside a part of an edge of the electrode layer 908. The electrode layer 908 is disposed at an inner side of the edge surrounding part 909a, and the edge surrounding part 909a overlaps with the electrode layer 905. The edge surrounding part 906a and the edge surrounding part 909a partially overlap to form a surrounding edge.

As shown in FIG. 9a, a resonance region 910 (i.e., the overlap region that the electrode layer 905 and the edge surrounding part 906a overlap with the electrode layer 908 and the edge surrounding part 909a) is suspended relative to the cavity 903 and does not overlap with the intermediate layer 902. Therefore, acoustic waves in the transverse mode can be prevented from leaking into the intermediate layer 902 from lateral edges of the resonance region 910, so as to raise the Q value.

In some embodiments, the substrate 901 is made of one or more materials selected from but not limited to a group consisting of silicon, silicon carbide, glass, gallium arsenide, gallium nitride, and ceramic.

In some embodiments, the intermediate layer 902 is made of one or more materials selected from but not limited to a group consisting of polymer, insulating dielectric, and polysilicon. In some embodiments, the polymer includes, but is not limited to, at least one selected from a group consisting of benzocyclobutene (i.e., BCB), photosensitive epoxy resin photoresist (e.g., SU-8), and polyimide. In some embodiments, the insulating dielectric includes, but is not limited to, at least one selected from a group consisting of aluminum nitride, silicon dioxide, silicon nitride, and titanium oxide.

In some embodiments, the electrode layer 905 is made of one or more materials selected from but not limited to a group consisting of molybdenum, ruthenium, tungsten, platinum, iridium, aluminum, and beryllium.

In some embodiments, the edge structure 906 is made of a material including metal. In some embodiments, the edge structure 906 is made of one or more materials selected from but not limited to a group consisting of molybdenum, ruthenium, tungsten, platinum, iridium, aluminum, and beryllium. In some embodiments, the edge structure 906 and the electrode layer 905 may be made of the same material. In some embodiments, a first edge structure below the piezoelectric layer and the lower electrode layer may be made of different materials.

In some embodiments, a thickness of the edge structure 906 is greater than a thickness of the electrode layer 905. In some embodiments, a thickness of a first edge structure below the piezoelectric layer is less than a thickness of the lower electrode layer. In some embodiments, a thickness of the first edge structure below the piezoelectric layer equals to a thickness of the lower electrode layer.

In some embodiments, the piezoelectric layer 907 is a flat layer and also covers the intermediate layer 902 at the upper surface side. In some embodiments, the piezoelectric layer 907 is made of one or more materials selected from but not limited to a group consisting of aluminum nitride, aluminum nitride alloy, gallium nitride, zinc oxide, lithium tantalate, lithium niobate, lead zirconate titanate, and lead magnesium niobate-lead titanate.

In some embodiments, the piezoelectric layer 907 includes multiple crystal grains, the crystal grains include a first crystal grain and a second crystal grain, and the first crystal grain and the second crystal grain are any two crystal grains of the crystal grains. Those skilled in the art know that crystallographic orientation, crystal planes and the like can be represented based on a coordinate system.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction is within a range from 0 degree to 5 degrees, and the first direction being opposite to the second direction means that the included angle between the vector along the first direction and the vector along the second direction is within a range from 175 degrees to 180 degrees.

In some embodiments, the first stereoscopic coordinate system is an ac stereoscopic coordinate system, and the first coordinate axis is a first c-axis and the third coordinate axis is a first a-axis. The second stereoscopic coordinate system is an ac stereoscopic coordinate system, and the second coordinate axis is a second c-axis, and the fourth coordinate axis is a second a-axis. The first c-axis and the second c-axis have the same orientation or opposite orientations.

In some embodiments, the first stereoscopic coordinate system further includes a fifth coordinate axis along a fifth direction, and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction is within a range from 0 degree to 5 degrees, and the third direction being opposite to the fourth direction means that the included angle between the vector along the third direction and the vector along the fourth direction is within a range from 175 degrees to 180 degrees.

In some embodiments, the first stereoscopic coordinate system is an xyz stereoscopic coordinate system, and the first coordinate axis is a first z-axis, the third coordinate axis is a first y-axis, and the fifth coordinate axis is a first x-axis. The second stereoscopic coordinate system is an xyz stereoscopic coordinate system, and the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientations, and the first y-axis and the second y-axis have opposite orientations. In some embodiments, the first z-axis and the second z-axis have the same orientation, and the first y-axis and the second y-axis have opposite orientations. In some embodiments, the first z-axis and the second z-axis have opposite orientations, and the first y-axis and the second y-axis have the same orientation.

In some embodiments, the piezoelectric layer 907 includes crystal grains, and a crystal composed of crystal grains has a full width at half maximum of a rocking curve less than 2.5 degrees.

It should be noted that the piezoelectric layer 907 formed on a planar surface may not include a crystal grain that is turned significantly, thereby increasing the electromechanical coupling coefficient and the Q value of the resonance device.

In some embodiments, the electrode layer 908 is made of one or more materials selected from but not limited to a group consisting of molybdenum, ruthenium, tungsten, platinum, iridium, aluminum, and beryllium.

In some embodiments, a part of the electrode layer 905 that overlaps with the electrode layer 908 is disposed in the cavity 903; and a part of the electrode 908 that overlaps with the electrode 905 is disposed above the cavity 903.

In some embodiments, the edge structure 909 is made of a material including metal. In some embodiments, the edge structure 909 is made of one or more materials selected from but not limited to a group consisting of molybdenum, ruthenium, tungsten, platinum, iridium, aluminum, and beryllium. In some embodiments, the edge structure 909 and the electrode layer 908 may be made of the same material. In some embodiments, a second edge structure on the piezoelectric layer and the upper electrode layer may be made of different materials.

In some embodiments, a thickness of the edge structure 909 is greater than a thickness of the electrode layer 908. In some embodiments, a thickness of a second edge structure on the piezoelectric layer is less than a thickness of the upper electrode layer. In some embodiments, a thickness of the second edge structure on the piezoelectric layer equals to a thickness of the upper electrode layer.

In some embodiments, the edge surrounding part 906a is disposed in the resonance region 910, the edge surrounding part 909a is disposed in the resonance region 910, and the edge surrounding part 906a and the edge surrounding part 909a partially overlap to form the surrounding edge of the resonance region 910. It should be noted that, an acoustic impedance of an edge part 911 in the resonance region 910 is greater than an acoustic impedance of a middle part 912 in the resonance region 910, and the acoustic impedance of the edge part 911 is greater than the acoustic impedance of the non-resonant region. Therefore, acoustic waves in the transverse mode can be reflected at lateral edges of the resonance region 910 and remain in the resonance region 910, resulting in a raise of the Q value.

In some embodiments, a surface at an inner side of the edge surrounding part 906a is a straight surface, and a surface at an inner side of the edge surrounding part 909a is a straight surface. In some embodiments, a surface at an inner side of the edge surrounding parts may be a slope surface.

FIG. 9b schematically illustrates a top-view structural diagram of the bulk acoustic wave resonance device 900 according to some embodiments of the present disclosure.

As shown in FIG. 9b, in some embodiments, the edge surrounding part 906a has an overlap part 913 with the edge surrounding part 909a, forming a surrounding edge of the resonance region 910 and thus can prevent leakage of transverse waves. In some embodiments, the surrounding edge formed by the edge surrounding part 906a and the edge surrounding part 909a is in an annular shape. In some embodiments, the surrounding edge formed by the edge surrounding part 906a and the edge surrounding part 909a is in an octagonal shape. It should be noted that other shapes of the edge surrounding part known to those skilled in the art, such as hexagons, pentagons, etc., may also be applied to the embodiments of the present disclosure.

FIG. 9c schematically illustrates a structural diagram of a cross-section B of the bulk acoustic wave resonance device 900 according to some embodiments of the present disclosure. FIG. 9c illustrates a structure of a cross-section B of the overlap part 913.

FIG. 10 schematically illustrates a structural diagram of a cross-section A of a bulk acoustic wave resonance device 1000 according to some embodiments of the present disclosure.

As shown in FIG. 10, some embodiments of the present disclosure provide a bulk acoustic wave resonance device 1000. The bulk acoustic wave resonance device 1000 includes: a substrate 1001; an intermediate layer 1002 disposed on the substrate 1001 and including a cavity 1003 and a groove 1004 disposed at an upper surface side of the intermediate layer 1002; an electrode layer 1005 disposed in the cavity 1003; an edge structure 1006; a piezoelectric layer 1007 disposed on the electrode layer 1005, on the edge structure 1006, and on the intermediate layer 1002; an electrode layer 1008; and an edge structure 1009. The groove 1004 is disposed at one side of the cavity 1003 and communicates with the cavity 1003, and a depth of the groove 1004 is less than a depth of the cavity 1003. The edge structure 1006 includes an edge surrounding part 1006a and an extension part 1006b, the edge surrounding part 1006a is disposed in the cavity 1003 and disposed beside an edge of the electrode layer 1005, and the electrode layer 1005 is disposed inside the edge surrounding part 1006a (i.e., an inner side directing to a central axis of the resonance device 1000). One end of the extension part 1006b is connected to the edge surrounding part 1006a, and the other end of the extension part 1006b is disposed in the groove 1004. A depth of the groove 1004 equals to a thickness of the edge structure 1006. The piezoelectric layer 1007 covers the cavity 1003 and includes a first side 1007a and a second side 1007b opposite to the first side 1007a. The electrode layer 1005, the edge structure 1006 and the intermediate layer 1002 are disposed at the first side 1007a. The electrode layer 1008 is disposed at the second side 1007b and on the piezoelectric layer 1007. The edge structure 1009 is disposed at the second side 1007b and on the piezoelectric layer 1007, the edge structure 1009 includes an edge surrounding part 1009a disposed beside an edge of the electrode layer 1008, and the electrode layer 1008 is disposed inside the edge surrounding part 1009a. The edge surrounding part 1009a and the edge surrounding part 1006a overlap to form a surrounding edge.

As shown in FIG. 10, a resonance region 1010 (i.e., the overlap region that the electrode layer 1005 and the edge surrounding part 1006a overlap with the electrode layer 1008 and the edge surrounding part 1009a) is suspended relative to the cavity 1003 and does not overlap with the intermediate layer 1002. Therefore, acoustic waves in the transverse mode can be prevented from leaking into the intermediate layer 1002 from lateral edges of the resonance region 1010, so as to raise the Q value.

In some embodiments, the substrate 1001 is made of one or more materials selected from but not limited to a group consisting of silicon, silicon carbide, glass, gallium arsenide, gallium nitride, and ceramic.

In some embodiments, the intermediate layer 1002 is made of one or more materials selected from but not limited to a group consisting of polymer, insulating dielectric, and polysilicon. In some embodiments, the polymer includes, but is not limited to, at least one selected from a group consisting of benzocyclobutene (i.e., BCB), photosensitive epoxy resin photoresist (e.g., SU-8), and polyimide. In some embodiments, the insulating dielectric includes, but is not limited to, at least one selected from a group consisting of aluminum nitride, silicon dioxide, silicon nitride, and titanium oxide.

In some embodiments, the electrode layer 1005 is made of one or more materials selected from but not limited to a group consisting of molybdenum, ruthenium, tungsten, platinum, iridium, aluminum, and beryllium.

In some embodiments, the edge structure 1006 is made of a material including metal. In some embodiments, the edge structure 1006 is made of one or more materials selected from but not limited to a group consisting of molybdenum, ruthenium, tungsten, platinum, iridium, aluminum, and beryllium. In some embodiments, the edge structure 1006 and the electrode layer 1005 may be made of the same material. In some embodiments, a first edge structure below the piezoelectric layer and the lower electrode layer may be made of different materials.

In some embodiments, a thickness of the edge structure 1006 is greater than a thickness of the electrode layer 1005. In some embodiments, a thickness of a first edge structure below the piezoelectric layer is less than a thickness of the lower electrode layer. In some embodiments, a thickness of the first edge structure below the piezoelectric layer equals to a thickness of the lower electrode layer.

In some embodiments, the piezoelectric layer 1007 is a flat layer and also covers the intermediate layer 1002 at the upper surface side. In some embodiments, the piezoelectric layer 1007 is made of one or more materials selected from but not limited to a group consisting of aluminum nitride, aluminum nitride alloy, gallium nitride, zinc oxide, lithium tantalate, lithium niobate, lead zirconate titanate, and lead magnesium niobate-lead titanate.

In some embodiments, the piezoelectric layer 1007 includes multiple crystal grains, the crystal grains include a first crystal grain and a second crystal grain, and the first crystal grain and the second crystal grain are any two crystal grains of the crystal grains. Those skilled in the art know that crystallographic orientation, crystal planes and the like can be represented based on a coordinate system.

In some embodiments, the first crystal grain may be represented based on a first stereoscopic coordinate system, and the second crystal grain may be represented based on a second stereoscopic coordinate system. The first stereoscopic coordinate system includes at least a first coordinate axis along a first direction and a third coordinate axis along a third direction, and the second stereoscopic coordinate system includes at least a second coordinate axis along a second direction and a fourth coordinate axis along a fourth direction. The first coordinate axis corresponds to a height of the first crystal grain, and the second coordinate axis corresponds to a height of the second crystal grain.

In some embodiments, the first direction is the same as or opposite to the second direction. It should be noted that the first direction being the same as the second direction means that an included angle between a vector along the first direction and a vector along the second direction is within a range from 0 degree to 5 degrees, and the first direction being opposite to the second direction means that the included angle between the vector along the first direction and the vector along the second direction is within a range from 175 degrees to 180 degrees.

In some embodiments, the first stereoscopic coordinate system is an ac stereoscopic coordinate system, and the first coordinate axis is a first c-axis and the third coordinate axis is a first a-axis. The second stereoscopic coordinate system is an ac stereoscopic coordinate system, and the second coordinate axis is a second c-axis, and the fourth coordinate axis is a second a-axis. The first c-axis and the second c-axis have the same orientation or opposite orientations.

In some embodiments, the first stereoscopic coordinate system further includes a fifth coordinate axis along a fifth direction, and the second stereoscopic coordinate system further includes a sixth coordinate axis along a sixth direction. In some embodiments, the first direction is the same as or opposite to the second direction, and the third direction is the same as or opposite to the fourth direction. It should be noted that the third direction being the same as the fourth direction means that an included angle between a vector along the third direction and a vector along the fourth direction is within a range from 0 degree to 5 degrees, and the third direction being opposite to the fourth direction means that the included angle between the vector along the third direction and the vector along the fourth direction is within a range from 175 degrees to 180 degrees.

In some embodiments, the first stereoscopic coordinate system is an xyz stereoscopic coordinate system, and the first coordinate axis is a first z-axis, the third coordinate axis is a first y-axis, and the fifth coordinate axis is a first x-axis. The second stereoscopic coordinate system is an xyz stereoscopic coordinate system, and the second coordinate axis is a second z-axis, the fourth coordinate axis is a second y-axis, and the sixth coordinate axis is a second x-axis. In some embodiments, the first z-axis and the second z-axis have the same orientation, and the first y-axis and the second y-axis have the same orientation. In some embodiments, the first z-axis and the second z-axis have opposite orientations, and the first y-axis and the second y-axis have opposite orientations. In some embodiments, the first z-axis and the second z-axis have the same orientation, and the first y-axis and the second y-axis have opposite orientations. In some embodiments, the first z-axis and the second z-axis have opposite orientations, and the first y-axis and the second y-axis have the same orientation.

In some embodiments, the piezoelectric layer 1007 includes crystal grains, and a crystal composed of crystal grains has a full width at half maximum of a rocking curve less than 2.5 degrees.

It should be noted that the piezoelectric layer 1007 formed on a planar surface may not include a crystal grain that is turned significantly, thereby increasing the electromechanical coupling coefficient and the Q value of the resonance device.

In some embodiments, the electrode layer 1008 is made of one or more materials selected from but not limited to a group consisting of molybdenum, ruthenium, tungsten, platinum, iridium, aluminum, and beryllium.

In some embodiments, a part of the electrode layer 1005 that overlaps with the electrode layer 1008 is disposed in the cavity 1003; and a part of the electrode 1008 that overlaps with the electrode 1005 is disposed above the cavity 1003.

In some embodiments, the edge structure 1009 is made of a material including metal. In some embodiments, the edge structure 1009 is made of one or more materials selected from but not limited to a group consisting of molybdenum, ruthenium, tungsten, platinum, iridium, aluminum, and beryllium. In some embodiments, the edge structure 1009 and the electrode layer 1008 may be made of the same material. In some embodiments, a second edge structure on the piezoelectric layer and the upper electrode layer may be made of different materials.

In some embodiments, a thickness of the edge structure 1009 is greater than a thickness of the electrode layer 1008. In some embodiments, a thickness of a second edge structure on the piezoelectric layer is less than a thickness of the upper electrode layer. In some embodiments, a thickness of the second edge structure on the piezoelectric layer equals to a thickness of the upper electrode layer.

In some embodiments, the edge surrounding part 1006a is disposed in the resonance region 1010, the edge surrounding part 1009a is disposed in the resonance region 1010, and the edge surrounding part 1006a and the edge surrounding part 1009a overlap to form the surrounding edge of the resonance region 1010. It should be noted that, an acoustic impedance of an edge part 1011 in the resonance region 1010 is greater than an acoustic impedance of a middle part 1012 in the resonance region 1010, and the acoustic impedance of the edge part 1011 is greater than the acoustic impedance of the non-resonant region. Therefore, acoustic waves in the transverse mode can be reflected at lateral edges of the resonance region 1010 and remain in the resonance region 1010, resulting in a raise of the Q value.

In some embodiments, a surface at an inner side of the edge surrounding part 1006a is a straight surface, and a surface at an inner side of the edge surrounding part 1009a is a straight surface. In some embodiments, a surface at an inner side of the edge surrounding parts may be a slope surface.

FIG. 11 schematically illustrates a structural diagram of a wireless communication device 1100. As shown in FIG. 11, the wireless communication device 1100 includes: a radio frequency front-end device 1110, a baseband processing device 1130 and an antenna 1150. A first end of the radio frequency front-end device 1110 is connected with the baseband processing device 1130, and a second end of the radio frequency front-end device 1110 is connected with the antenna 1150. The radio frequency front-end device 1110 includes: a filter device 1111, a filter device 1113, a multiplexing device 1115, a power amplification device 1117 and a low noise amplification device 1119. The filter device 1111 is electrically coupled with the power amplification device 1117. The filter device 1113 is electrically coupled with the low noise amplification device 1119. The multiplexing device 1115 includes at least one transmitting filter device (not shown) and at least one receiving filter device (not shown). The filter device 1111 includes at least one bulk acoustic wave resonance device according to any one of preceding embodiments, and the filter device 1113 includes at least one bulk acoustic wave resonance device according to any one of preceding embodiments. The at least one transmitting filter device includes at least one bulk acoustic wave resonance device according to any one of preceding embodiments, or the at least one receiving filter device includes at least one bulk acoustic wave resonance device according to any one of preceding embodiments.

To sum up, the resonance region of the bulk acoustic wave resonance device provided by the embodiments of the present disclosure is suspended relative to the cavity and does not overlap with the intermediate layer of the bulk acoustic wave resonance device, the resonance region includes edge structure(s), and the edge part of the resonance region, where the edge structure is disposed, does not match a middle part of the resonance region inside the edge structure in acoustic impedance (that is, the acoustic impedances are different), which can cut down leakage waves at lateral edges of the resonance region in the transverse mode so as to raise the Q value.

It should be understood that examples and embodiments herein are only exemplary, and those skilled in the art can make various modifications and corrections without departing from the spirit and scope of the present disclosure.

## Claims

1. A bulk acoustic wave resonance device, **characterized by** comprising:
a first layer, comprising a cavity;
a first electrode layer, wherein at least one end of the first electrode layer is disposed in the cavity;
a piezoelectric layer disposed on the first electrode layer and covering the cavity, wherein the piezoelectric layer comprises a first side and a second side opposite to the first side along a vertical direction, and the first electrode layer is disposed at the first side;
a second electrode layer, disposed at the second side and on the piezoelectric layer; and
at least one edge structure, disposed at an edge of an overlap part of the first electrode layer and the second electrode layer along a horizontal direction, and being asymmetrical with respect to the piezoelectric layer along the vertical direction.

2. The bulk acoustic wave resonance device according to claim 1, **characterized in that** the at least one edge structure comprises a first edge structure disposed at the second side and on the second electrode layer, the first edge structure comprises a first edge surrounding part and a first extension part, the first edge surrounding part is disposed at the edge of the overlap part of the first electrode layer and the second electrode layer, the first extension part is connected to the first edge surrounding part and is disposed at an outer side of the overlap part of the first electrode layer and the second electrode layer, and the first extension part does not overlap with the first electrode layer, resulting in a reduction to the resistance in electrical transmission.

3. The bulk acoustic wave resonance device according to claim 2, **characterized in that** the first edge surrounding part is in an annular shape.

4. The bulk acoustic wave resonance device according to claim 2, **characterized in that** the first edge structure is made of a material comprising metal.

5. The bulk acoustic wave resonance device according to claim 1, **characterized in that** the at least one edge structure comprises a second edge structure, the first electrode layer is disposed on the second edge structure, the second edge structure comprises a second edge surrounding part and a second extension part, the second edge surrounding part is disposed in the cavity and disposed at the edge of the overlap part of the first electrode layer and the second electrode layer, the second extension part is connected to the second edge surrounding part and is disposed at an outer side of the overlap part of the first electrode layer and the second electrode layer, and the second extension part does not overlap with the second electrode layer, resulting in a reduction to the resistance in electrical transmission.

6. The bulk acoustic wave resonance device according to claim 5, **characterized in that** the second edge surrounding part is in an annular shape.

7. The bulk acoustic wave resonance device according to claim 5, **characterized in that** the second edge structure is made of a material comprising metal.

8. The bulk acoustic wave resonance device according to claim 1, **characterized in that** the at least one edge structure comprises a third edge structure disposed at the second side and on the second electrode layer, the third edge structure comprises a third edge surrounding part, and the third edge surrounding part is disposed at a part of the edge of the overlap part of the first electrode layer and the second electrode layer.

9. The bulk acoustic wave resonance device according to claim 8, **characterized in that** the at least one edge structure further comprises a fourth edge structure, the first electrode layer is disposed on the fourth edge structure, the fourth edge structure comprises a fourth edge surrounding part, and the fourth edge surrounding part is disposed in the cavity and disposed at a part of the edge of the overlap part of the first electrode layer and the second electrode layer.

10. The bulk acoustic wave resonance device according to claim 9, **characterized in that** the third edge surrounding part and the fourth edge surrounding part are disposed at both sides of the piezoelectric layer and form an asymmetrical structure along the vertical direction, and the third edge surrounding part and the fourth edge surrounding part partially overlap to form an annular surrounding edge.

11. The bulk acoustic wave resonance device according to claim 9, **characterized in that** the third edge structure is made of a material comprising metal, and the fourth edge structure is made of a material comprising metal.

12. The bulk acoustic wave resonance device according to claim 1, **characterized in that** the at least one edge structure comprises a fifth edge structure disposed at the second side and on the piezoelectric layer, the fifth edge structure comprises a fifth edge surrounding part and a fifth extension part, an overlap part of the fifth edge surrounding part and the first electrode layer is formed along the vertical direction, the second electrode layer is disposed at an inner side of the overlap part of the fifth edge surrounding part and the first electrode layer, a part of the second electrode layer overlapping with the first electrode layer is equivalent to the second electrode layer, the fifth extension part is connected to the fifth edge surrounding part and is disposed at an outer side of the overlap part of the fifth edge surrounding part and the first electrode layer, and the fifth extension part does not overlap with the first electrode layer, resulting in a reduction to the resistance in electrical transmission.

13. The bulk acoustic wave resonance device according to claim 12, **characterized in that** the fifth edge surrounding part is in an annular shape.

14. The bulk acoustic wave resonance device according to claim 12, **characterized in that** the fifth edge structure is made of a material comprising metal.

15. The bulk acoustic wave resonance device according to claim 1, **characterized in that** the at least one edge structure comprises a sixth edge structure disposed at the first side, the piezoelectric layer is disposed on the sixth edge structure, the sixth edge structure comprises a sixth edge surrounding part and a sixth extension part, the sixth edge surrounding part is disposed in the cavity, an overlap part of the sixth edge surrounding part and the second electrode layer is formed along the vertical direction, the first electrode layer is disposed at an inner side of the overlap part of the sixth edge surrounding part and the second electrode layer, a part of the first electrode layer overlapping with the second electrode layer is equivalent to the first electrode layer, the sixth extension part is connected to the sixth edge surrounding part and is disposed at an outer side of the overlap part of the sixth edge surrounding part and the second electrode layer, and the sixth extension part does not overlap with the second electrode layer, resulting in a reduction to the resistance in electrical transmission.

16. The bulk acoustic wave resonance device according to claim 15, **characterized in that** the sixth edge surrounding part is in an annular shape.

17. The bulk acoustic wave resonance device according to claim 15, **characterized in that** the sixth edge structure is made of a material comprising metal.

18. The bulk acoustic wave resonance device according to claim 1, **characterized in that** the at least one edge structure comprises a seventh edge structure disposed at the second side and on the piezoelectric layer, the seventh edge structure comprises a seventh edge surrounding part, and the seventh edge surrounding part is disposed at a part of the edge of the overlap part of the first electrode layer and the second electrode layer.

19. The bulk acoustic wave resonance device according to claim 18, **characterized in that** the at least one edge structure further comprises an eighth edge structure disposed at the first side, the piezoelectric layer is disposed on the eighth edge structure, the eighth edge structure comprises an eighth edge surrounding part, and the eighth edge surrounding part is disposed in the cavity and disposed at a part of the edge of the overlap part of the first electrode layer and the second electrode layer.

20. The bulk acoustic wave resonance device according to claim 19, **characterized in that** the seventh edge surrounding part and the eighth edge surrounding part are disposed at both sides of the piezoelectric layer and form an asymmetrical structure along the vertical direction, and the eighth edge surrounding part and the seventh edge surrounding part partially overlap to form an annular surrounding edge.

21. The bulk acoustic wave resonance device according to claim 19, **characterized in that** the seventh edge structure is made of a material comprising metal, and the eighth edge structure is made of a material comprising metal.

22. The bulk acoustic wave resonance device of claim 1, **characterized in that** the first layer comprises an intermediate layer, the intermediate layer comprises the cavity, and the intermediate layer is made of a material comprising at least one selected from a group consisting of polymer, insulating dielectric, and polysilicon.

23. The bulk acoustic wave resonance device of claim 1, **characterized in that** the piezoelectric layer comprises a plurality of crystal grains, the plurality of crystal grains comprises a first crystal grain and a second crystal grain, the first crystal grain and the second crystal grain are any two crystal grains of the plurality of crystal grains, a first coordinate axis along a first direction corresponds to a height of the first crystal grain, a second coordinate axis along a second direction corresponds to a height of the second crystal grain, and the first direction is the same as or opposite to the second direction.

24. The bulk acoustic wave resonance device of claim 23, **characterized in that** the first crystal grain corresponds to a first coordinate system, the first coordinate system comprises the first coordinate axis and a third coordinate axis along a third direction, the second crystal grain corresponds to a second coordinate system, and the second coordinate system comprises the second coordinate axis and a fourth coordinate axis along a fourth direction.

25. The bulk acoustic wave resonance device of claim 24, **characterized in that** the first coordinate system further comprises a fifth coordinate axis along a fifth direction, and the second coordinate system further comprises a sixth coordinate axis along a sixth direction.

26. The bulk acoustic wave resonance device of claim 25, **characterized in that** the third direction is the same as or opposite to the fourth direction.

27. The bulk acoustic wave resonance device of claim 1, **characterized in that** the piezoelectric layer comprises a plurality of crystal grains, and a crystal composed of the plurality of crystal grains has a full width at half maximum of a rocking curve less than 2.5 degrees.

28. A filter device, **characterized by** comprising: at least one bulk acoustic wave resonance device according to any one of claims 1 to 27.

29. A radio frequency front-end device, **characterized by** comprising: a power amplification device and at least one filter device according to claim 28; wherein the power amplification device is coupled with the at least one filter device.

30. A radio frequency front-end device, **characterized by** comprising: a low noise amplification device and at least one filter device according to claim 28; wherein the low noise amplification device is coupled with the at least one filter device.

31. A radio frequency front-end device, **characterized by** comprising: a multiplexing device comprising at least one filter device according to claim 28.
